# EUROPEAN PATENT APPLICATION

(11) **EP 4 642 208 A1**
(43) Date of publication of application: **29.10.2025**
(21) Application number: 25167572.4
(22) Date of filing: 31.03.2025
(51) Int. Cl.: H10K 59/80

(54) **DISPLAY DEVICE**

(30) Priority: 02.04.2024 KR 20240044781
(71) Applicant: Samsung Display Co., Ltd., Yongin-si, Gyeonggi-do 17113 (KR)
(72) Inventor: CHO, Young Jin, 17113 Yongin-si (KR); KIM, Han Sol, 17113 Yongin-si (KR); MOON, Joong Soo, 17113 Yongin-si (KR); LEE, Chang Yeol, 17113 Yongin-si (KR); JO, Eun Byul, 17113 Yongin-si (KR)
(74) Representative: Walaski, Jan Filip

(57) **Abstract**

A display device includes: a display panel including: a plurality of light emitting elements in a display area for displaying an image; and an inorganic area in a non-display area around the display area. Each of the plurality of light emitting elements includes: a pixel electrode; a light emitting layer on the pixel electrode; and a common electrode on the light emitting layer. The display panel includes a first side, a second side opposite to the first side, and a third side connected to the first side and the second side. In the non-display area on the first side of the display panel, the common electrode overlaps with the inorganic area, and in the non-display area on the third side of the display panel, the common electrode is spaced from the inorganic area.

## Description

### BACKGROUND

### 1. Field

The present disclosure relates to a display device.

### 2. Description of the Related Art

As information society develops, the demand for display devices for displaying images has increased and diversified. The display devices may be flat panel display devices, such as liquid crystal displays (LCDs), field emission displays (FEDs), or light emitting displays (LEDs). The light emitting display may include an organic light emitting display device including organic light emitting elements, an inorganic light emitting display device including inorganic light emitting elements such as inorganic semiconductors, and a micro light emitting display device including micro light emitting elements.

Recently, in display devices, an area of a display area where pixels for displaying an image are disposed has increased, and an area of a bezel area or a dead space area corresponding to a non-display area excluding the display area has decreased. Accordingly, some structures disposed in the non-display area may be exposed without being covered by a light blocking layer of a cover substrate. In this case, external light may be diffusely reflected from these structures disposed in the non-display area, and as such, the visibility of the image displayed in the display area may be lowered.

The above information disclosed in this Background section is for enhancement of understanding of the background of the present disclosure, and therefore, it may contain information that does not constitute prior art.

### SUMMARY

One or more embodiments of the present disclosure may be directed to a display device capable of preventing or reducing the visibility of an image displayed in a display area from being lowered by external light.

However, the aspects and features of the present disclosure are not limited to those set forth herein. The above and other aspects and features of the present disclosure will be set forth, in part, in the detailed description below with reference to the drawings, and in part, may be apparent therefrom, or may be learned by practicing one or more of the presented embodiments of the present disclosure.

According to one or more embodiments of the present disclosure, a display device includes: a display panel including: a plurality of light emitting elements in a display area for displaying an image; and an inorganic area in a non-display area around the display area. Each of the plurality of light emitting elements includes: a pixel electrode; a light emitting layer on the pixel electrode; and a common electrode on the light emitting layer. The display panel includes a first side, a second side opposite to the first side, and a third side connected to the first side and the second side. In the non-display area on the first side of the display panel, the common electrode overlaps with the inorganic area, and in the non-display area on the third side of the display panel, the common electrode is spaced from the inorganic area.

In an embodiment, the display device may further include a cover substrate on the display panel, and including a light blocking layer. In the non-display area on the first side of the display panel, the light blocking layer may overlap with the inorganic area, and in the non-display area on the third side of the display panel, the light blocking layer may not overlap with the inorganic area.

In an embodiment, in the non-display area on the first side of the display panel, the common electrode may overlap with the light blocking layer, and in the non-display area on the third side of the display panel, the common electrode may not overlap with the light blocking layer.

In an embodiment, the display panel may further include a first corner where the first side and the third side meet each other, and in the non-display area at the first corner of the display panel, an edge of the common electrode and the inorganic area may cross each other.

In an embodiment, the display panel may further include a first corner where the first side and the third side meet each other, and in the non-display area at the first corner of the display panel, an edge of the common electrode and an edge of the light blocking layer may cross each other.

In an embodiment, the display panel may further include a first corner where the first side and the third side meet each other, and in the non-display area at the first corner of the display panel, an edge of the light blocking layer and an edge of the inorganic area may cross each other.

In an embodiment, the display panel may further include: first scan lines extending in a first direction; second scan lines extending in the first direction; a first scan driver in the non-display area on the first side of the display panel, and configured to output first scan signals to the first scan lines; and a second scan driver in the non-display area on the first side of the display panel, and configured to output second scan signals to the second scan lines. In the non-display area on the first side of the display panel, the inorganic area may be located between the first scan driver and the second scan driver.

In an embodiment, in the non-display area on the first side of the display panel, the common electrode may overlap with the first scan driver and the second scan driver.

In an embodiment, in the non-display area on the first side of the display panel, the light blocking layer may overlap with the first scan driver and the second scan driver.

In an embodiment, in the non-display area on the first side of the display panel, the light blocking layer may overlap with the second scan driver, and may not overlap with the first scan driver.

In an embodiment, the display panel may further include: third scan lines extending in the first direction; and a third scan driver in the non-display area on the first side of the display panel, and configured to output third scan signals to the third scan lines. In the non-display area on the first side of the display panel, the third scan driver may be located between the first scan driver and the inorganic area.

In an embodiment, in the non-display area on the first side of the display panel, the common electrode may overlap with the first scan driver, the second scan driver, and the third scan driver.

In an embodiment, in the non-display area on the first side of the display panel, the light blocking layer may overlap with the first scan driver, the second scan driver, and the third scan driver.

In an embodiment, in the non-display area on the first side of the display panel, the light blocking layer may overlap with the second scan driver and the third scan driver, and may not overlap with the first scan driver.

In an embodiment, in the non-display area on the first side of the display panel, the light blocking layer may overlap with the third scan driver, and may not overlap with the first scan driver and the second scan driver.

In an embodiment, the display panel may further include: a first encapsulation inorganic film on the plurality of light emitting elements; an encapsulation organic film on the first encapsulation inorganic film; and a second encapsulation inorganic film on the encapsulation organic film. The non-display area may include an inorganic encapsulation area where the first encapsulation inorganic film and the second encapsulation inorganic film are in contact with each other, and the inorganic encapsulation area may be more adjacent to an edge of the display panel than the inorganic area is.

In an embodiment, the display panel may further include a dam in the non-display area, and confining the encapsulation organic film. The inorganic encapsulation area may be more adjacent to the dam than the inorganic area.

According to one or more embodiments of the present disclosure, a display device includes: a display panel including: a plurality of light emitting elements in a display area for displaying an image; and an inorganic area in a non-display area around the display area; and a cover substrate on the display panel, and including a light blocking layer. Each of the plurality of light emitting elements includes: a pixel electrode; a light emitting layer on the pixel electrode; and a common electrode on the light emitting layer. The display panel includes a first side, a second side opposite to the first side, and a third side connected to the first side and the second side. In the non-display area on the first side of the display panel, the common electrode overlaps with the light blocking layer, and in the non-display area on the third side of the display panel, the common electrode does not overlap with the light blocking layer.

In an embodiment, in the non-display area on the first side of the display panel, the common electrode may overlap with the inorganic area, and in the non-display area on the third side of the display panel, the common electrode may be spaced from the inorganic area.

In an embodiment, in the non-display area on the first side of the display panel, the light blocking layer may overlap with the inorganic area, and in the non-display area on the third side of the display panel, the light blocking layer may not overlap with the inorganic area.

According to one or more embodiments of the present disclosure, a display device includes: a substrate including a display area, and a non-display area around the display area; at least one inorganic film on the substrate; a first organic film on the at least one inorganic film; a second organic film on the first organic film; a pixel electrode on the second organic film in the display area; a light emitting layer on the pixel electrode; and a common electrode on the light emitting layer. The non-display area includes an inorganic area having a groove penetrating through the first organic film and the second organic film, the common electrode is located in the inorganic area of the non-display area on a first side of the substrate, and the common electrode is spaced from the inorganic area of the non-display area on a side of the substrate adjacent to the first side of the substrate.

In an embodiment, the display device may further include: a first sub-power line on the first organic film in the non-display area; and a second sub-power line on the second organic film in the non-display area.

In an embodiment, the first sub-power line and the second sub-power line may be located in the groove of the inorganic area, the first sub-power line and the second sub-power line located in the groove of the inorganic area of the non-display area on the first side of the substrate may be connected to the common electrode, and the first sub-power line and the second sub-power line located in the groove of the inorganic area of the non-display area on the side of the substrate may be spaced from the common electrode.

In an embodiment, the display device may further include a first power connection electrode on the at least one inorganic film, and connected to the first sub-power line in the groove of the inorganic area.

In an embodiment, the display device may further include: a second power connection electrode on the at least one inorganic film, and connected to the first sub-power line; a first encapsulation inorganic film on the common electrode; an encapsulation organic film on the first encapsulation inorganic film; a second encapsulation inorganic film on the encapsulation organic film; and a dam in the non-display area, and confining the encapsulation organic film. The dam may be located on the second power connection electrode.

In an embodiment, the display device may further include a scan transistor on the substrate, and covered by the at least one inorganic film. The first sub-power line and the second sub-power line may overlap with the scan transistor.

According to some embodiments of the present disclosure, in a non-display area on a first side of a display panel, a light blocking layer disposed on one surface of a cover substrate may overlap with a groove of an inorganic area. Therefore, it may be possible to prevent or substantially prevent external light from being incident on the groove of the inorganic area. Accordingly, it may be possible to prevent or substantially prevent the external light from being unpredictably diffusely reflected by a common electrode disposed on sidewalls of the groove of the inorganic area, and thus, it may be possible to prevent or reduce the visibility of an image displayed in a display area from being lowered.

According to some embodiments of the present disclosure, in a non-display area on a side of the display panel, an inorganic area may be exposed without being covered by the light blocking layer of the cover substrate, but a common electrode may be disposed away from the inorganic area, and thus, may not be disposed in a groove of the inorganic area. Therefore, even though external light may be incident on the inorganic area, a diffuse reflection of the external light may be reduced or prevented. Accordingly, it may be possible to prevent or reduce the visibility of the image displayed in the display area from being lowered.

### BRIEF DESCRIPTION OF THE DRAWINGS

The above and other aspects and features of the present disclosure will be more clearly understood from the following detailed description of the illustrative, non-limiting embodiments with reference to the accompanying drawings, in which:
FIG. 1 is a perspective view illustrating a display device;
FIG. 2 is a layout diagram illustrating a display panel;
FIG. 3 is a block diagram illustrating the display device;
FIG. 4 is an equivalent circuit diagram illustrating a sub-pixel;
FIG. 5 is a layout diagram illustrating an example of a display area of FIG. 2 in more detail;
FIGS. 6-8 are layout diagrams illustrating examples of the area A1 in FIG. 2 in more detail;
FIGS. 9 and 10 are layout diagrams illustrating examples of the area A2 in FIG. 2 in more detail;
FIGS. 11-13 are layout diagrams illustrating examples of the area A3 in FIG. 2 in more detail;
FIG. 14 is a cross-sectional view of the display panel taken along the line I1-I1' in FIG. 5;
FIG. 15 is a cross-sectional view of the display panel taken along the line I2-I2' of FIGS. 6 through 8;
FIG. 16 is a cross-sectional view of the display panel taken along the line I3-I3' of FIGS. 9 and 10; and
FIG. 17 is a perspective view illustrating an electronic device to which the display device is applied.

### DETAILED DESCRIPTION

Hereinafter, embodiments will be described in more detail with reference to the accompanying drawings, in which like reference numbers refer to like elements throughout. The present disclosure, however, may be embodied in various different forms, and should not be construed as being limited to only the illustrated embodiments herein. Rather, these embodiments are provided as examples so that this disclosure will be thorough and complete, and will fully convey the aspects and features of the present disclosure to those skilled in the art. Accordingly, processes, elements, and techniques that are not necessary to those having ordinary skill in the art for a complete understanding of the aspects and features of the present disclosure may not be described. Unless otherwise noted, like reference numerals denote like elements throughout the attached drawings and the written description, and thus, redundant description thereof may not be repeated.

When a certain embodiment may be implemented differently, a specific process order may be different from the described order. For example, two consecutively described processes may be performed at the same or substantially at the same time, or may be performed in an order opposite to the described order.

Further, as would be understood by a person having ordinary skill in the art, in view of the present disclosure in its entirety, each suitable feature of the various embodiments of the present disclosure may be combined or combined with each other, partially or entirely, and may be technically interlocked and operated in various suitable ways, and each embodiment may be implemented independently of each other or in conjunction with each other in any suitable manner, unless otherwise stated or implied.

In the drawings, the relative sizes, thicknesses, and ratios of elements, layers, and regions may be exaggerated and/or simplified for clarity. Spatially relative terms, such as "beneath," "below," "lower," "under," "above," "upper," and the like, may be used herein for ease of explanation to describe one element or feature's relationship to another element(s) or feature(s) as illustrated in the figures. It will be understood that the spatially relative terms are intended to encompass different orientations of the device in use or in operation, in addition to the orientation depicted in the figures. For example, if the device in the figures is turned over, elements described as "below" or "beneath" or "under" other elements or features would then be oriented "above" the other elements or features. Thus, the example terms "below" and "under" can encompass both an orientation of above and below. The device may be otherwise oriented (e.g., rotated 90 degrees or at other orientations) and the spatially relative descriptors used herein should be interpreted accordingly.

Additionally, the use of cross-hatching and/or shading in the accompanying drawings is generally provided to clarify boundaries between adjacent elements. As such, neither the presence nor the absence of cross-hatching or shading conveys or indicates any preference or requirement for particular materials, material properties, dimensions, proportions, commonalities between illustrated elements, and/or any other characteristic, attribute, property, etc., of the elements, unless specified.

As used herein, the phrases "on a plane" and "in a plan view" mean viewing a target portion from the top, and the phrase "on a cross-section" means viewing a cross-section formed by vertically cutting a target portion from the side.

Further, it should be expected that the shapes shown in the figures may vary in practice depending, for example, on tolerances and/or manufacturing techniques. Accordingly, the embodiments of the present disclosure should not be construed as being limited to the specific shapes shown in the figures, and should be construed considering changes in shapes that may occur, for example, as a result of manufacturing. As such, the shapes shown in the drawings may not depict the actual shapes of areas of the device, and the present disclosure is not limited thereto.

For example, an implanted region illustrated as a rectangle may have rounded or curved features and/or a gradient of implant concentration at its edges rather than a binary change from implanted to non-implanted region. Likewise, a buried region formed by implantation may result in some implantation in the region between the buried region and the surface through which the implantation takes place. Thus, the regions illustrated in the drawings are schematic in nature and their shapes are not intended to illustrate the actual shape of a region of a device and are not intended to be limiting. Additionally, as those skilled in the art would realize, the described embodiments may be modified in various different ways, all without departing from the scope of the present disclosure.

Also, any numerical range disclosed and/or recited herein is intended to include all sub-ranges of the same numerical precision subsumed within the recited range. For example, a range of "1.0 to 10.0" is intended to include all subranges between (and including) the recited minimum value of 1.0 and the recited maximum value of 10.0, for example, having a minimum value equal to or greater than 1.0 and a maximum value equal to or less than 10.0, such as, for example, 2.4 to 7.6. Any maximum numerical limitation recited herein is intended to include all lower numerical limitations subsumed therein, and any minimum numerical limitation recited in this specification is intended to include all higher numerical limitations subsumed therein. Accordingly, Applicant reserves the right to amend this specification, including the claims, to expressly recite any sub-range subsumed within the ranges expressly recited herein.

In the figures, the x-axis, the y-axis, and the z-axis are not limited to three axes of the rectangular coordinate system, and may be interpreted in a broader sense. For example, the x-axis, the y-axis, and the z-axis may be perpendicular to or substantially perpendicular to one another, or may represent different directions from each other that are not perpendicular to one another.

It will be understood that, although the terms "first," "second," "third," etc., may be used herein to describe various elements, components, regions, layers and/or sections, these elements, components, regions, layers and/or sections should not be limited by these terms. These terms are used to distinguish one element, component, region, layer or section from another element, component, region, layer or section. Thus, a first element, component, region, layer or section described below could be termed a second element, component, region, layer or section, without departing from the scope of the present disclosure.

It will be understood that when an element or layer is referred to as being "on," "connected to," or "coupled to" another element or layer, it can be directly on, connected to, or coupled to the other element or layer, or one or more intervening elements or layers may be present. Similarly, when a layer, an area, or an element is referred to as being "electrically connected" to another layer, area, or element, it may be directly electrically connected to the other layer, area, or element, and/or may be indirectly electrically connected with one or more intervening layers, areas, or elements therebetween. In addition, it will also be understood that when an element or layer is referred to as being "between" two elements or layers, it can be the only element or layer between the two elements or layers, or one or more intervening elements or layers may also be present.

The terminology used herein is for the purpose of describing particular embodiments and is not intended to be limiting of the present disclosure. As used herein, the singular forms "a" and "an" are intended to include the plural forms as well, unless the context clearly indicates otherwise. It will be further understood that the terms "comprises," "comprising," "includes," "including," "has," "have," and "having," when used in this specification, specify the presence of the stated features, integers, steps, operations, elements, and/or components, but do not preclude the presence or addition of one or more other features, integers, steps, operations, elements, components, and/or groups thereof. As used herein, the term "and/or" includes any and all combinations of one or more of the associated listed items. For example, the expression "A and/or B" denotes A, B, or A and B. Expressions such as "at least one of," when preceding a list of elements, modify the entire list of elements and do not modify the individual elements of the list. For example, the expression "at least one of a, b, or c," "at least one of a, b, and c," and "at least one selected from the group consisting of a, b, and c" indicates only a, only b, only c, both a and b, both a and c, both b and c, all of a, b, and c, or variations thereof.

As used herein, the term "substantially," "about," and similar terms are used as terms of approximation and not as terms of degree, and are intended to account for the inherent variations in measured or calculated values that would be recognized by those of ordinary skill in the art. Further, the use of "may" when describing embodiments of the present disclosure refers to "one or more embodiments of the present disclosure." As used herein, the terms "use," "using," and "used" may be considered synonymous with the terms "utilize," "utilizing," and "utilized," respectively.

The electronic or electric devices and/or any other relevant devices or components according to embodiments of the present disclosure described herein may be implemented utilizing any suitable hardware, firmware (e.g. an application-specific integrated circuit), software, or a combination of software, firmware, and hardware. For example, the various components of these devices may be formed on one integrated circuit (IC) chip or on separate IC chips. Further, the various components of these devices may be implemented on a flexible printed circuit film, a tape carrier package (TCP), a printed circuit board (PCB), or formed on one substrate. Further, the various components of these devices may be a process or thread, running on one or more processors, in one or more computing devices, executing computer program instructions and interacting with other system components for performing the various functionalities described herein. The computer program instructions are stored in a memory which may be implemented in a computing device using a standard memory device, such as, for example, a random access memory (RAM). The computer program instructions may also be stored in other non-transitory computer readable media such as, for example, a CD-ROM, flash drive, or the like. Also, a person of skill in the art should recognize that the functionality of various computing devices may be combined or integrated into a single computing device, or the functionality of a particular computing device may be distributed across one or more other computing devices without departing from the scope of the example embodiments of the present disclosure.

Unless otherwise defined, all terms (including technical and scientific terms) used herein have the same meaning as commonly understood by one of ordinary skill in the art to which the present disclosure belongs. It will be further understood that terms, such as those defined in commonly used dictionaries, should be interpreted as having a meaning that is consistent with their meaning in the context of the relevant art and/or the present specification, and should not be interpreted in an idealized or overly formal sense, unless expressly so defined herein.

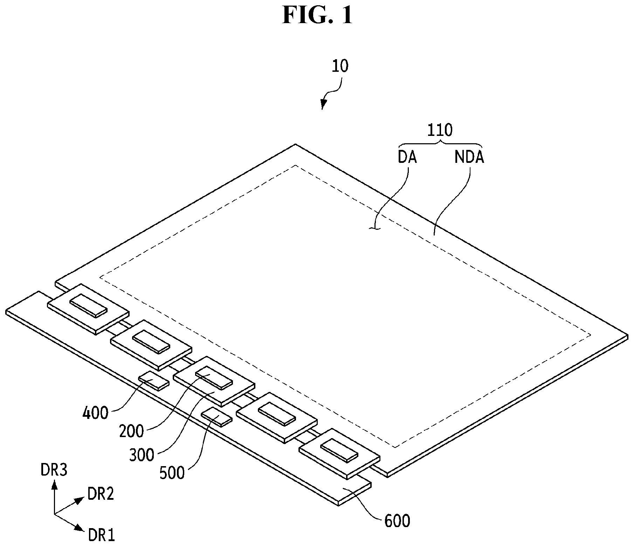

FIG. 1 is a perspective view illustrating a display device.

Referring to FIG. 1, a display device 10 may display a moving image and/or a still image. The display device 10 may be used as a display screen of various suitable products, such as televisions, laptop computers, monitors, billboards, and Internet of Things (IOT) devices, as well as for various suitable portable electronic devices, such as mobile phones, smartphones, tablet personal computers (PCs), smart watches, watch phones, mobile communication terminals, electronic notebooks, electronic books, portable multimedia players (PMPs), navigation devices, and ultra mobile PCs (UMPCs).

The display device 10 may be a light emitting display device, such as an organic light emitting display device including organic light emitting diodes, a quantum dot light emitting display device including quantum dot light emitting layers, an inorganic light emitting display device including inorganic semiconductors, and a micro light emitting display device including micro or nano light emitting diodes (micro LEDs or nano LEDs). Hereinafter, the display device 10 may be mainly described in more detail in the context of the organic light emitting display device, but it is not limited thereto.

The display device 10 includes a display panel 110, a plurality of source drivers 200, a plurality of flexible circuit boards 300, a timing controller 400, a power supply unit (e.g., a power supply or a power supply controller) 500, and a circuit board 600.

The display panel 110 may be formed in a rectangular shape, in a plan view, having long sides extending in a first direction DR1, and short sides extending in a second direction DR2 crossing the first direction DR1. A corner where a long side extending in the first direction DR1 and a short side extending in the second direction DR2 meet each other may be rounded with a suitable curvature (e.g., a predetermined curvature), or may be right-angled. A shape of the display panel 110 in a plan view is not limited to the rectangular shape, and may be other polygonal shapes, a circular shape, or an elliptical shape. The display panel 110 may be formed to be flat or substantially flat, but it is not limited thereto. As an example, the display panel 110 may include curved surface portions formed at left and right ends thereof, and having a constant curvature or a variable curvature. As another example, or in addition, the display panel 110 may be flexibly formed to be curved, bent, folded, or rolled.

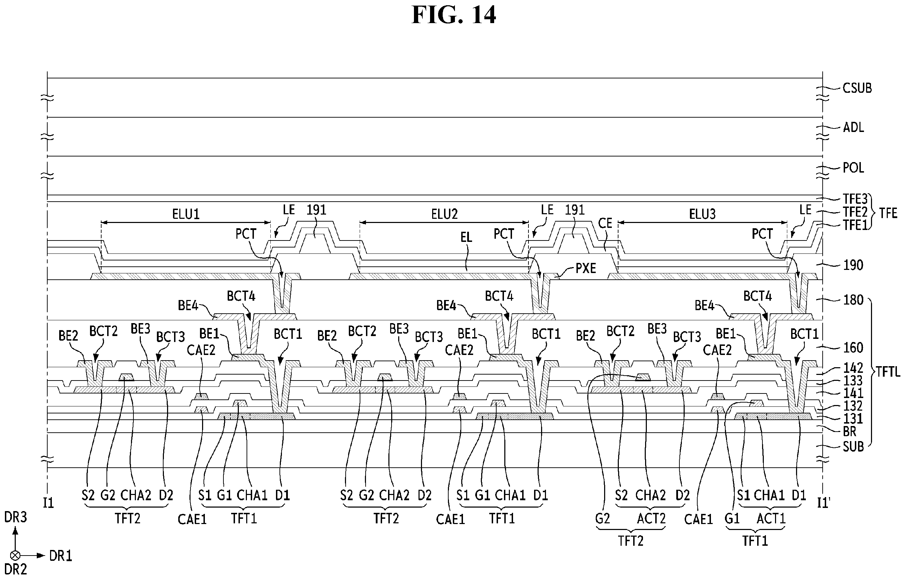

The display panel 110 may include a display area DA for displaying an image, and a non-display area NDA disposed around the display area DA. A substrate SUB (e.g., see FIGS. 14 to 17) of the display panel 110 may include the display area DA and the non-display area NDA.

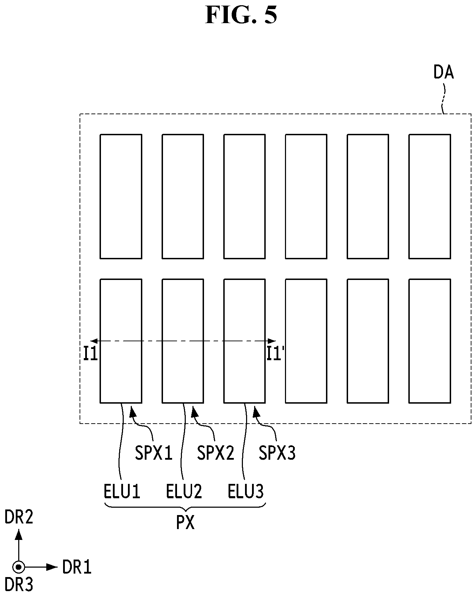

The display area DA may occupy most of the area of the display panel 110. The display area DA may be disposed at the center of the display panel 110. A plurality of pixels PX (e.g., see FIG. 5) may be disposed in the display area DA in order to display an image.

The non-display area NDA may be an area that does not display the image. The non-display area NDA may be an edge area of the display panel 110. The non-display area NDA may be an area outside the display area DA. The non-display area NDA may be disposed to surround (e.g., around a periphery of) the display area DA.

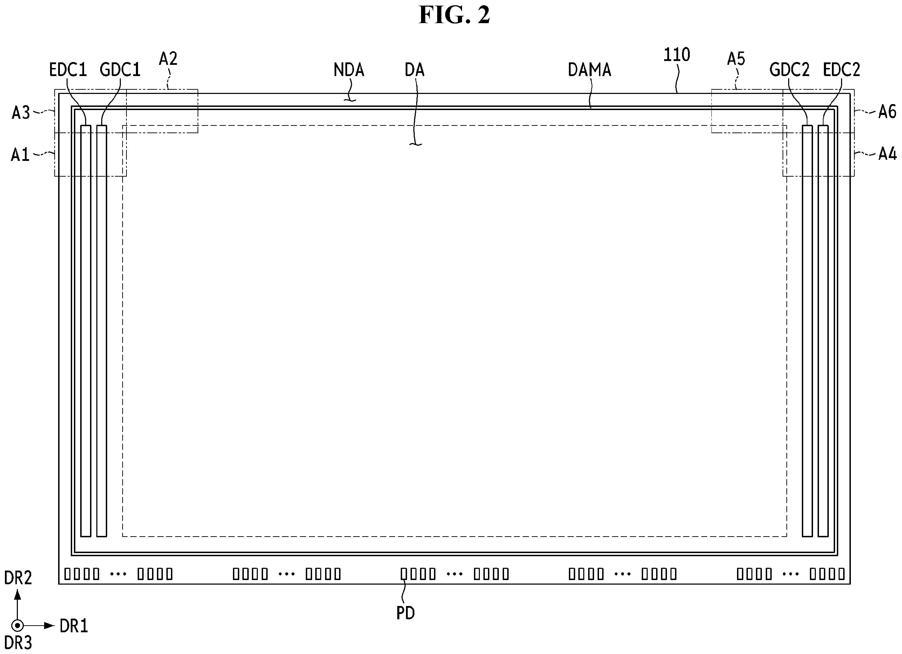

Display pads PD (e.g., see FIG. 2) may be disposed in the non-display area NDA, in order to be connected to the plurality of flexible circuit boards 300. The display pads PD (e.g., see FIG. 2) may be disposed on an edge of one side of the display panel 110.

Each of the source drivers 200 may be formed as an integrated circuit (IC) and attached to a corresponding flexible circuit board 300, but the present disclosure is not limited thereto. Each of the source drivers 200 may be attached onto the display panel 110 in a chip on glass (COG) manner, a chip on plastic (COP) manner, or an ultrasonic bonding manner.

Each of the plurality of flexible circuit boards 300 may be disposed on the display pads PD (e.g., see FIG. 2) disposed on the edge of one side of the display panel 110. Each of the plurality of flexible circuit boards 300 may be attached to the display pads PD (e.g., see FIG. 2) using a conductive adhesive member, such as an anisotropic conductive film. Accordingly, the plurality of flexible circuit boards 300 may be electrically connected to signal lines of the display panel 110. Each of the plurality of flexible circuit boards 300 may be a flexible printed circuit board or a flexible film, such as a chip on film.

The timing controller 400 may generate timing control signals for controlling the timings of scan drivers GDC1 and GDC2 (e.g., see FIG. 2), emission drivers EDC1 and EDC2, and the source drivers 200. The power supply unit 500 may generate a plurality of source voltages for driving the display panel 110 according to input power input from the outside. Each of the timing controller 400 and the power supply unit 500 may be formed as an integrated circuit (IC), and may be attached onto the circuit board 600.

The circuit board 600 may be connected to one side of each of the plurality of flexible circuit boards 300. The circuit board 600 may be a rigid printed circuit board.

FIG. 2 is a layout diagram illustrating a display panel.

Referring to FIG. 2, the display panel 110 includes display pads PD, a first scan driver GDC1, a first emission driver EDC1, a second scan driver GDC2, a second emission driver EDC2, and a dam area DAMA.

The display pads PD may be disposed on an edge of one side of the display panel 110. The display pads PD may be divided into a plurality of groups. When the display device 10 includes five flexible circuit boards 300 as illustrated in FIG. 1, the display pads PD may be divided into five groups. The display pads PD of each of the plurality of groups may correspond to bumps of the corresponding flexible circuit board 300 in a one-to-one manner. Therefore, the display pads PD of each of the plurality of groups may be electrically connected to the corresponding flexible circuit board 300.

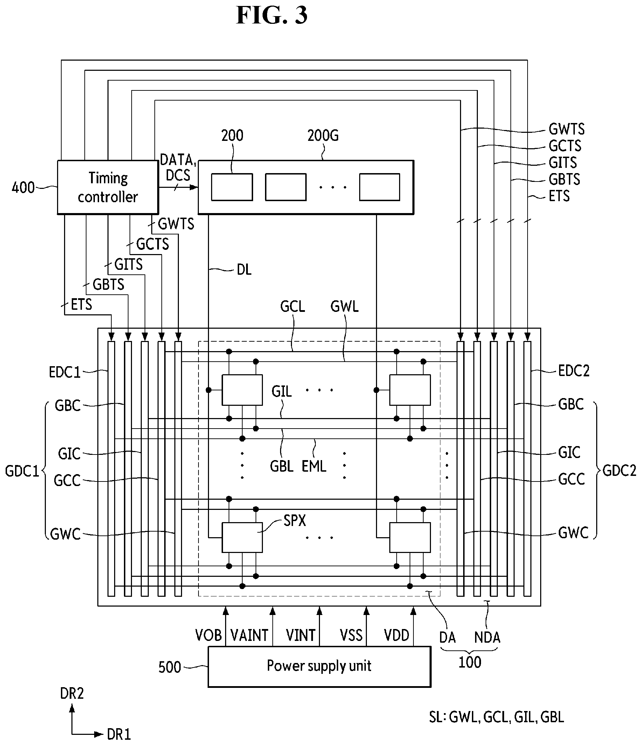

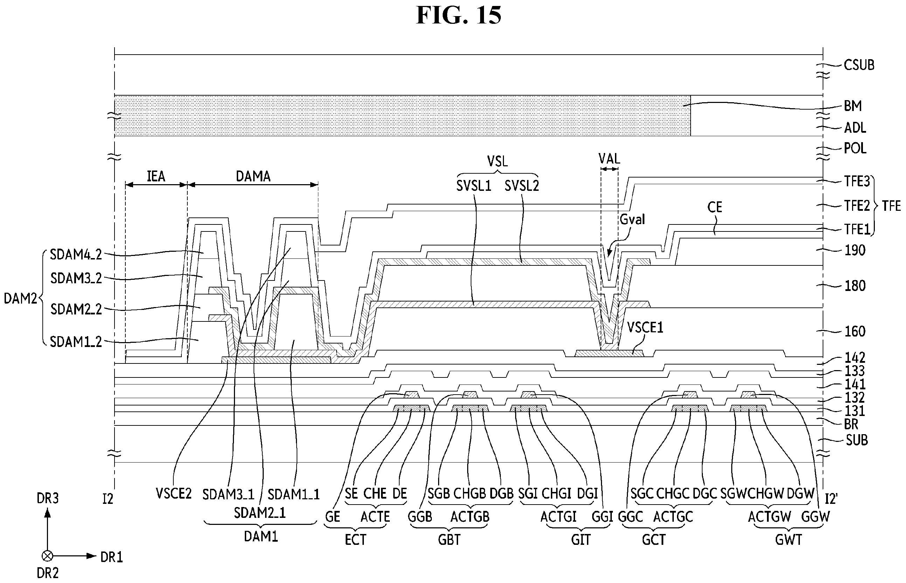

Some of the display pads PD may be electrically connected to data lines DL (e.g., see FIG. 3) disposed in the display area DA. Some others of the display pads PD may be electrically connected to the first scan driver GDC1, the second scan driver GDC2, the first emission driver EDC1, and the second emission driver EDC2. Some others of the display pads PD may be connected to a first power line VSL (e.g., see FIG. 15) to which a first source voltage is applied.

The first power line VSL (e.g., see FIG. 15) may be disposed to surround at least three sides of the display area DA. For example, the first power line VSL (e.g., see FIG. 15) may be disposed to surround the left side, the upper side, and the right side of the display area DA. As another example, the first power line VSL (e.g., see FIG. 15) may be arranged to surround the left side, the upper side, the right side, and the lower side of the display area DA.

The first scan driver GDC1 and the second scan driver GDC2 may be electrically connected to scan lines SL (e.g., see FIG. 3) of the display area DA. The first scan driver GDC1 may be disposed in the non-display area NDA on a first side (e.g., the left side) of the display panel 110. The second scan driver GDC2 may be disposed in the non-display area NDA on a second side (e.g., the right side) of the display panel 110.

The first emission driver EDC1 and the second emission driver EDC2 may be electrically connected to emission control lines EML (e.g., see FIG. 3) of the display area DA. The first emission driver EDC1 may be disposed in the non-display area NDA on the first side (e.g., the left side) of the display panel 110. The second emission driver EDC2 may be disposed in the non-display area NDA on the second side (e.g., the right side) of the display panel 110.

The first scan driver GDC1 may be disposed between the display area DA and the first emission driver EDC1. The first scan driver GDC1 may be disposed closer to the display area DA than the first emission driver EDC1 is. In addition, the first emission driver EDC1 may be disposed closer to an edge of the first side of the display panel 110 than the first scan driver GDC1 is.

The second scan driver GDC2 may be disposed between the display area DA and the second emission driver EDC2. The second scan driver GDC2 may be disposed closer to the display area DA than the second emission driver EDC2 is. In addition, the second emission driver EDC2 may be disposed closer to an edge of the second side of the display panel 110 than the second scan driver GDC2 is.

The dam area DAMA includes at least one dam DM1 and DM2 (e.g., see FIG. 15) for preventing or substantially preventing an encapsulation organic film TFE2 from overflowing onto the display pads PD. The dam area DAMA may be arranged to surround (e.g., around a periphery of) the display area DA.

The dam area DAMA may be disposed outside the first emission driver EDC1 and the second emission driver EDC2. The dam area DAMA may be disposed closer to the edge of the first side of the display panel 110 than the first emission driver EDC1 is. In addition, the dam area DAMA may be disposed closer to the edge of the second side of the display panel 110 than the second emission driver EDC2 is.

FIG. 3 is a block diagram illustrating the display device.

Referring to FIG. 3, the display area DA includes a plurality of sub-pixels SPX, a plurality of scan lines SL, a plurality of emission control lines EML, and a plurality of data lines DL.

The plurality of sub-pixels SPX may be arranged in a matrix form along the first direction DR1 and the second direction DR2. The plurality of scan lines SL and the plurality of emission control lines EML may extend in the first direction DR1, and may be arranged along the second direction DR2. The plurality of data lines DL may extend in the second direction DR2, and may be arranged along the first direction DR1. The plurality of scan lines SL includes a plurality of write scan lines GWL, a plurality of control scan lines GCL, a plurality of initialization scan lines GIL, and a plurality of bias scan lines GBL.

Each of the plurality of sub-pixels SPX may be connected to any one of the plurality of write scan lines GWL, any one of the plurality of control scan lines GCL, any one of the plurality of initialization scan lines GIL, any one of the plurality of bias scan lines GBL, any one of the plurality of emission control lines EML, and any one of the plurality of data lines DL. Each of the plurality of sub-pixels SPX may receive a data voltage of the corresponding data line DL according to a write scan signal of the corresponding write scan line GWL, and may allow a light emitting element to emit light according to the data voltage.

The non-display area NDA includes the first scan driver GDC1, the second scan driver GDC2, the first emission driver EDC1, and the second emission driver EDC2.

Each of the first scan driver GDC1 and the second scan driver GDC2 may include a write scan driver GWC, a control scan driver GCC, an initialization scan driver GIC, and a bias scan driver GBC. FIG. 3 illustrates that the write scan driver GWC, the control scan driver GCC, the initialization scan driver GIC, and the bias scan driver GBC are sequentially disposed from the display area DA to an edge of the display panel 110, but the present disclosure is not limited thereto.

The write scan driver GWC may receive a write timing signal GWTS from the timing controller 400. The write scan driver GWC may generate write scan signals according to the write timing signal GWTS, and may sequentially output the write scan signals to the write scan lines GWL.

The control scan driver GCC may receive a control timing signal GCTS from the timing controller 400. The control scan driver GCC may generate control scan signals according to the control timing signal GCTS, and may sequentially output the control scan signals to the control scan lines GCL.

The initialization scan driver GIC may receive an initialization timing signal GITS from the timing controller 400. The initialization scan driver GIC may generate initialization scan signals according to the initialization timing signal GITS, and sequentially output the initialization scan signals to the initialization scan lines GIL.

The bias scan driver GBC may receive a bias timing signal GBTS from the timing controller 400. The bias scan driver GBC may generate bias scan signals according to the bias timing signal GBTS, and sequentially output the bias scan signals to the bias scan lines GBL.

Each of the first emission driver EDC1 and the second emission driver EDC2 may receive an emission timing signal ETS from the timing controller 400. Each of the first emission driver EDC1 and the second emission driver EDC2 may generate emission control signals according to the emission timing signal ETS, and sequentially output the emission control signals to the emission control lines EML.

A data driver 200G may include a plurality of source drivers 200. Each of the plurality of source drivers 200 may receive digital video data DATA and a data timing signal DCS from the timing controller 400. Each of the plurality of source drivers 200 converts the digital video data DATA into analog data voltages according to the data timing signal DCS, and outputs the analog data voltages to the data lines DL. In this case, the sub-pixels SPX may be selected by the write scan signals, and the data voltages may be supplied to the selected sub-pixels SPX.

The timing controller 400 may receive the digital video data DATA and timing signals from the outside. The timing controller 400 may generate the write timing signal GWTS, the control timing signal GCTS, the initialization timing signal GITS, the bias timing signal GBTS, and the emission timing signal ETS according to the timing signals. The timing controller 400 may output the write timing signal GWTS to the write scan drivers GWC, and output the control timing signal GCTS to the control scan drivers GCC. In addition, the timing controller 400 may output the initialization timing signal GITS to the initialization scan drivers GIC, and output the bias timing signal GBTS to the bias scan drivers GBC. The timing controller 400 may output the emission timing signal ETS to the first emission driver EDC1 and the second emission driver EDC2. In addition, the timing controller 400 may output the digital video data DATA and the data timing signal DCS to the source drivers 200.

The power supply unit 500 may generate a plurality of panel driving voltages according to an external source voltage. For example, the power supply unit 500 may generate a first source voltage VSS, a second source voltage VDD, a third source voltage VINT, a fourth source voltage VAINT, and a fifth source voltage VOB, and supply the first source voltage VSS, the second source voltage VDD, the third source voltage VINT, the fourth source voltage VAINT, and the fifth source voltage VOB to the display panel 110. The first source voltage VSS may be a low potential voltage, and the second source voltage VDD may be a high potential voltage. The third source voltage VINT may be a first initialization voltage, the fourth source voltage VAINT may be a second initialization voltage, and the fifth source voltage VOB may be a third initialization voltage. The third source voltage VINT, the fourth source voltage VAINT, and the fifth source voltage VOB may be voltages that are higher than that of the first source voltage VSS, and lower than that of the second source voltage VDD.

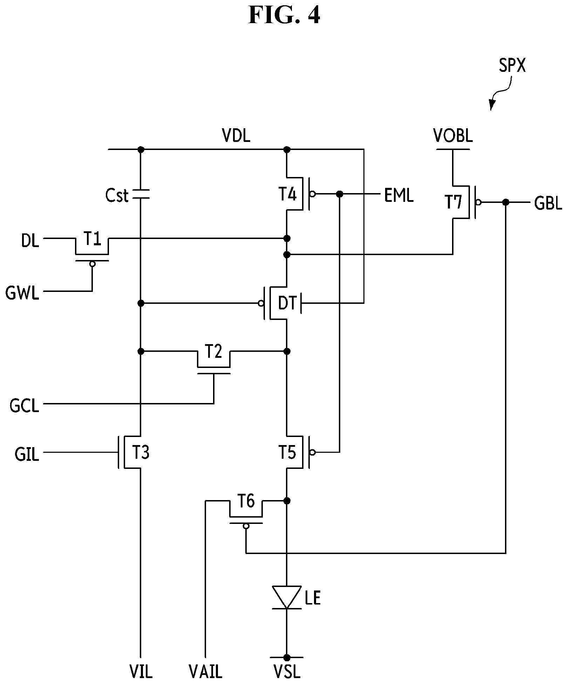

FIG. 4 is an equivalent circuit diagram illustrating a sub-pixel.

Referring to FIG. 4, the sub-pixel SPX may be connected to a write scan line GWL, an initialization scan line GIL, a control scan line GCL, a bias scan line GBL, an emission control line EML, and a data line DL.

The sub-pixel SPX includes a driving transistor DT, switch elements, a capacitor Cst, and a light emitting element LE. The switch elements may include first to seventh transistors T1, T2, T3, T4, T5, T6, and T7.

The driving transistor DT controls a source-drain current (hereinafter, referred to as a "driving current") according to a data voltage applied to a first electrode thereof.

The light emitting element LE may be an organic light emitting diode. The light emitting element LE may emit light according to the driving current. An amount of light emitted from the light emitting element LE may be proportional to the driving current. A first electrode of the light emitting element LE may be connected to a second electrode of the fifth transistor T5 and a first electrode of the sixth transistor T6. A second electrode of the light emitting element LE may be connected to a first power line VSL to which the first source voltage VSS is applied. The first electrode of the light emitting element LE may be an anode electrode or a pixel electrode, and the second electrode of the light emitting element LE may be a cathode electrode or a common electrode.

The first transistor T1 may be turned on by a write scan signal of a gate-on voltage applied to the write scan line GWL to connect the data line DL to the first electrode of the driving transistor DT. As such, the data voltage may be applied to the first electrode of the driving transistor DT during a period in which the first transistor T1 is turned on. A gate electrode of the first transistor T1 may be connected to the write scan line GWL, a first electrode of the first transistor T1 may be connected to the data line DL, and a second electrode of the first transistor T1 may be connected to the first electrode of the driving transistor DT.

The second transistor T2 may be turned on by a control scan signal of a gate-on voltage applied to the control scan line GCL to connect the gate electrode and a second electrode of the driving transistor DT to each other. During a period in which the second transistor T2 is turned on, the driving transistor DT may operate like a diode. In other words, the driving transistor DT may be diode-connected. A gate electrode of the second transistor T2 may be connected to the control scan line GCL, a first electrode of the second transistor T2 may be connected to the second electrode of the driving transistor DT, and a second electrode of the second transistor T2 may be connected to the gate electrode of the driving transistor DT.

The third transistor T3 may be turned on by an initialization scan signal of a gate-on voltage applied to the initialization scan line GIL to connect the gate electrode of the driving transistor DT to a third power line VIL. During a period in which the third transistor T3 is turned on, the gate electrode of the driving transistor DT may be initialized to the third source voltage VINT (e.g., see FIG. 3) of the third power line VIL. A gate electrode of the third transistor T3 may be connected to the initialization scan line GIL, a first electrode of the third transistor T3 may be connected to the gate electrode of the driving transistor DT, and a second electrode of the third transistor T3 may be connected to the third power line VIL.

The fourth transistor T4 may be turned on by an emission control signal of a gate-on voltage applied to the emission control line EML to connect the second power line VDL to the first electrode of the driving transistor DT. During a period in which the fourth transistor T4 is turned on, the second source voltage VDD (e.g., see FIG. 3) of the second power line VDL may be applied to the first electrode of the driving transistor DT. A gate electrode of the fourth transistor T4 may be connected to the emission control line EML, a first electrode of the fourth transistor T4 may be connected to the second power line VDL, and a second electrode of the fourth transistor T4 may be connected to the first electrode of the driving transistor DT.

The fifth transistor T5 may be turned on by the emission control signal of the gate-on voltage applied to the emission control line EML to connect the second electrode of the driving transistor DT to the first electrode of the light emitting element LE. During a period in which the fifth transistor T5 is turned on, the driving current of the driving transistor DT may be supplied to the light emitting element LE. A gate electrode of the fifth transistor T5 may be connected to the emission control line EML, the first electrode of the fifth transistor T5 may be connected to the second electrode of the driving transistor DT, and the second electrode of the fifth transistor T5 may be connected to the first electrode of the light emitting element LE.

The sixth transistor T6 may be turned on by a bias scan signal of a gate-on voltage applied to the bias scan line GBL to connect the first electrode of the light emitting element LE to a fourth power line VAIL. During a period in which the sixth transistor T6 is turned on, the first electrode of the light emitting element LE may be initialized to the fourth source voltage VAINT (e.g., see FIG. 3) of the fourth power line VAIL. A gate electrode of the sixth transistor T6 may be connected to the bias scan line GBL, the first electrode of the sixth transistor T6 may be connected to the first electrode of the light emitting element LE, and a second electrode of the sixth transistor T6 may be connected to the fourth power line VAIL.

The seventh transistor T7 may be turned on by the bias scan signal of the gate-on voltage applied to the bias scan line GBL to connect the first electrode of the driving transistor DT to a fifth power line VOBL. During a period in which the seventh transistor T7 is turned on, the first electrode of the driving transistor DT may be initialized to the fifth source voltage VOB (e.g., see FIG. 3) of the fifth power line VOBL. A gate electrode of the seventh transistor T7 may be connected to the bias scan line GBL, a first electrode of the seventh transistor T7 may be connected to the first electrode of the driving transistor DT, and a second electrode of the seventh transistor T7 may be connected to the fifth power line VOBL.

The capacitor Cst may be formed between the gate electrode of the driving transistor DT and the second power line VDL. One electrode of the capacitor Cst may be connected to the gate electrode of the driving transistor DT, and another electrode of the capacitor Cst may be connected to the second power line VDL.

The driving transistor DT, the first transistor T1, the fourth transistor T4, the fifth transistor T5, the sixth transistor T6, and the seventh transistor T7 may be formed as P-type metal oxide semiconductor field effect transistors (MOSFETs). In this case, an active layer of each of the driving transistor DT, the first transistor T1, the fourth transistor T4, the fifth transistor T5, the sixth transistor T6, and the seventh transistor T7 may be made of polysilicon. In addition, the driving transistor DT, the first transistor T1, the fourth transistor T4, the fifth transistor T5, the sixth transistor T6, and the seventh transistor T7 may be turned on by a signal of a gate low voltage.

The second transistor T2 and the third transistor T3 may be formed as N-type MOSFETs. In this case, an active layer of each of the second transistor T2 and the third transistor T3 may be made of an oxide semiconductor. In addition, the second transistor T2 and the third transistor T3 may be turned on by a signal of a gate high voltage.

FIG. 5 is a layout diagram illustrating an example of a display area of FIG. 2 in more detail.

Referring to FIG. 5, a plurality of pixels PX may be arranged in a matrix form. Each of the plurality of pixels PX may include a first light emitting unit (e.g., a first light emitting element) ELU1 of a first sub-pixel SPX1, a second light emitting unit (e.g., a second light emitting element) ELU2 of a second sub-pixel SPX2, and a third light emitting unit (e.g., a third light emitting element) ELU3 of a third sub-pixel SPX3.

In each of the plurality of pixels PX, the first light emitting unit ELU1, the second light emitting unit ELU2, and the third light emitting unit ELU3 may be arranged in a stripe shape. For example, in each of the plurality of pixels PX, the first light emitting unit ELU1, the second light emitting unit ELU2, and the third light emitting unit ELU3 may be arranged along the first direction DR1.

The first light emitting unit ELU1 may emit a first light, the second light emitting unit ELU2 may emit a second light, and the third light emitting unit ELU3 may emit a third light. The first light may be light of a blue wavelength band, the second light may be light of a green wavelength band, and the third light may be light of a red wavelength band. For example, the blue wavelength band indicates that a main peak wavelength of the light is included in a wavelength band of approximately 370 nm to 460 nm. The green wavelength band indicates that a main peak wavelength of the light is included in a wavelength band of approximately 480 nm to 560 nm. The red wavelength band indicates that a main peak wavelength of the light is included in a wavelength band of approximately 600 nm to 750 nm.

While FIG. 5 illustrates that each of the plurality of pixels PX includes three light emitting units (e.g., three light emitting elements) ELU1, ELU2, and ELU3, the present disclosure is not limited thereto. For example, each of the plurality of pixels PX may include four light emitting units (e.g., four light emitting elements). In this case, the first light emitting unit may emit a first light, the second light emitting unit and a fourth light emitting unit (e.g., a fourth light emitting element) may emit a second light, and the third light emitting unit may emit a third light. As another example, the first light emitting unit may emit a first light, the second light emitting unit may emit a second light, the third light emitting unit may emit a third light, and the fourth light emitting unit may emit a fourth light. The fourth light may be white light. In each of the plurality of pixels PX, the first light emitting unit, the second light emitting unit, the third light emitting unit, and the fourth light emitting unit may be arranged in a stripe shape or a diamond shape (e.g., a PENTILE^{®} shape, PENTILE^{®} being a duly registered trademark of Samsung Display Co., Ltd.).

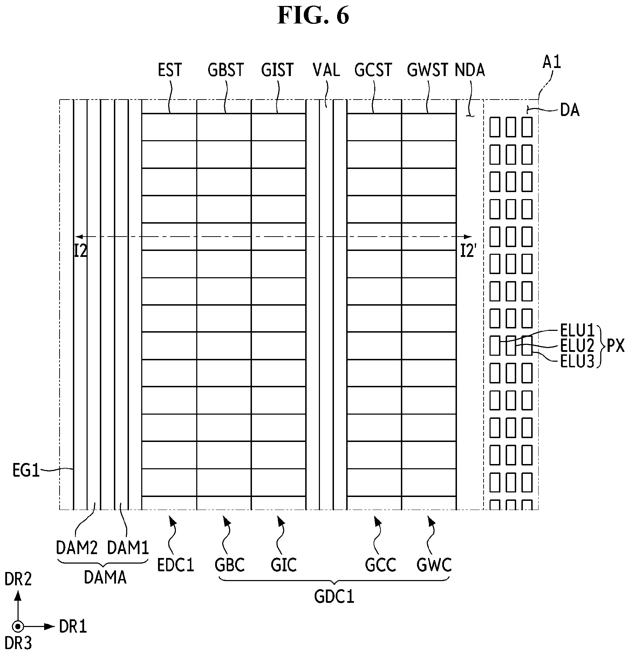

FIGS. 6 to 8 are layout diagrams illustrating examples of the area A1 in FIG. 2 in more detail.

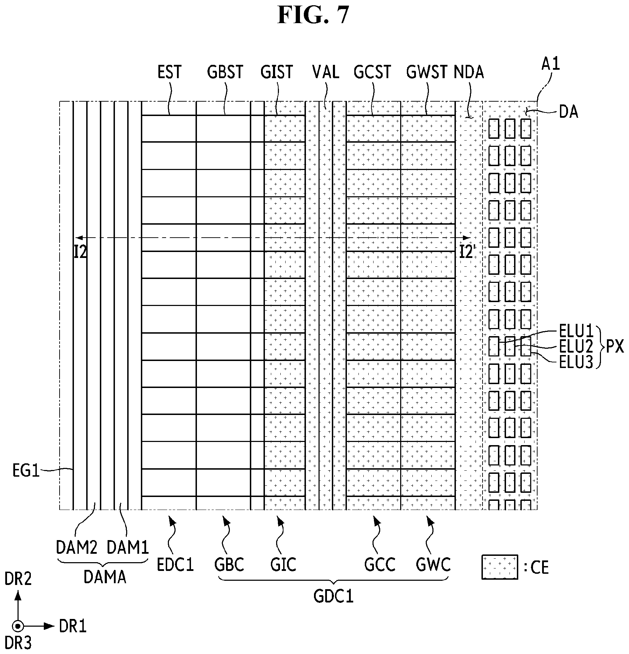

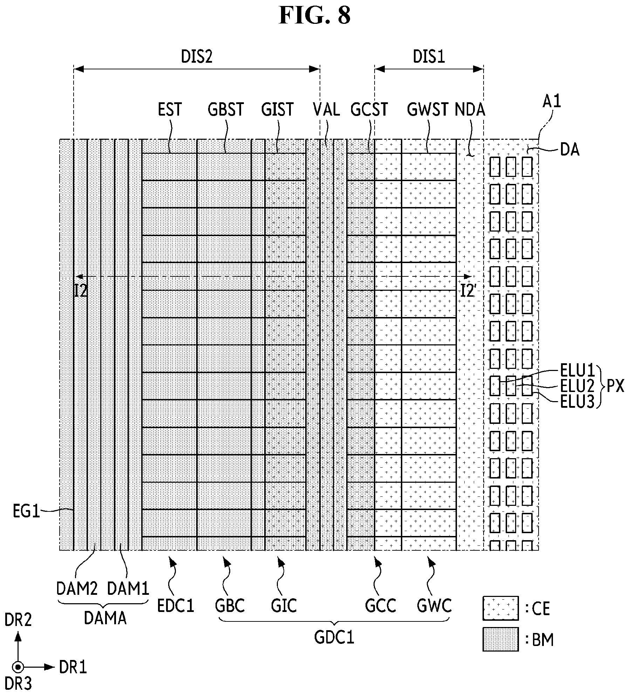

FIGS. 6 to 8 are layout diagrams illustrating, in more detail, the non-display area NDA disposed on the left side of the display panel 110 corresponding to the first side of the display panel 110. FIG. 7 is a diagram additionally illustrating a common electrode CE in addition to the structure illustrated in FIG. 6, and FIG. 8 is a diagram additionally illustrating a light blocking layer BM in addition to the structure illustrated in FIG. 7.

Referring to FIGS. 6 to 8, the first scan driver GDC1, the first emission driver EDC1, an inorganic area VAL, and the dam area DAMA may be disposed in the non-display area NDA on the first side of the display panel 110.

The first scan driver GDC1 may include the write scan driver GWC, the control scan driver GCC, the initialization scan driver GIC, and the bias scan driver GBC. The write scan driver GWC, the control scan driver GCC, the initialization scan driver GIC, and the bias scan driver GBC may be sequentially disposed from the display area DA toward an edge EG1 of the first side of the display panel 110. For example, the write scan driver GWC may be disposed to be most adjacent to the display area DA, and the bias scan driver GBC may be disposed to be most adjacent to the edge EG1 of the first side of the display panel 110, from among the first scan driver GDC1. In addition, the control scan driver GCC may be disposed to be closer to the write scan driver GWC than the initialization scan driver GIC is. In addition, the initialization scan driver GIC may be disposed to be closer to the bias scan driver GBC than the control scan driver GCC is.

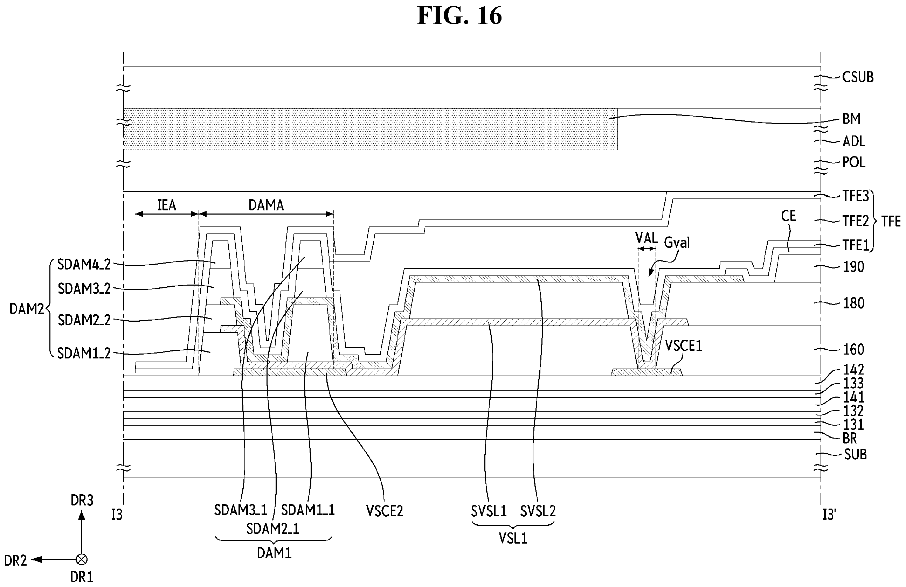

The write scan driver GWC includes a plurality of write scan stages GWST (e.g., see FIG. 6). In the non-display area NDA on the first side of the display panel 110, the plurality of write scan stages GWST may be arranged along the second direction DR2. The plurality of write scan stages GWST may be connected to each other in a cascade manner, and may be sequentially driven in the second direction DR2, and thus, may sequentially output the write scan signals to the write scan lines GWL (e.g., see FIG. 3). Each of the plurality of write scan stages GWST may output the corresponding write scan signal to the corresponding write scan line GWL (e.g., see FIG. 3) connected thereto. As such, each of the plurality of write scan stages GWST may include a plurality of write scan transistors GWT (e.g., see FIGS. 15 and 16).

The control scan driver GCC includes a plurality of control scan stages GCST. In the non-display area NDA on the first side of the display panel 110, the plurality of control scan stages GCST may be arranged along the second direction DR2. The plurality of control scan stages GCST may be connected to each other in a cascade manner, and may be sequentially driven in the second direction DR2, and thus, may sequentially output the control scan signals to the control scan lines GCL (e.g., see FIG. 3). Each of the plurality of control scan stages GCST may output the corresponding control scan signal to the corresponding control scan line GCL (e.g., see FIG. 3) connected thereto. As such, each of the plurality of control scan stages GCST may include a plurality of control scan transistors GCT (e.g., see FIGS. 15 and 16).

The initialization scan driver GIC includes a plurality of initialization scan stages GIST. In the non-display area NDA on the first side of the display panel 110, the plurality of initialization scan stages GIST may be arranged along the second direction DR2. The plurality of initialization scan stages GIST may be connected to each other in a cascade manner, and may be sequentially driven in the second direction DR2, and thus, may sequentially output the initialization scan signals to the initialization scan lines GIL (e.g., see FIG. 3). Each of the plurality of initialization scan stages GIST may output the corresponding initialization scan signal to the corresponding initialization scan line GIL (e.g., see FIG. 3) connected thereto. As such, each of the plurality of initialization scan stages GIST may include a plurality of initialization scan transistors GIT (e.g., see FIGS. 15 and 16).

The bias scan driver GBC includes a plurality of bias scan stages GBST. In the non-display area NDA on the first side of the display panel 110, the plurality of bias scan stages GBST may be arranged along the second direction DR2. The plurality of bias scan stages GBST may be connected to each other in a cascade manner, and may be sequentially driven in the second direction DR2, and thus, may sequentially output the bias scan signals to the bias scan lines GBL (e.g., see FIG. 3). Each of the plurality of bias scan stages GBST may output the corresponding bias scan signal to the corresponding bias scan line GBL (e.g., see FIG. 3) connected thereto. As such, each of the plurality of bias scan stages GBST may include a plurality of bias scan transistors GBT (e.g., see FIGS. 15 and 16).

The first emission driver EDC1 includes a plurality of emission stages EST. In the non-display area NDA on the first side of the display panel 110, the plurality of emission stages EST may be arranged along the second direction DR2. The plurality of emission stages EST may be connected to each other in a cascade manner, and may be sequentially driven in the second direction DR2, and thus, may sequentially output the emission control signals to the emission control lines EML (e.g., see FIG. 3). Each of the plurality of emission stages EST may output the corresponding emission control signal to the corresponding emission control line EML (e.g., see FIG. 3) connected thereto. As such, each of the plurality of emission stages EST may include a plurality of emission control transistors ECT (e.g., see FIGS. 15 and 16).

The dam area DAMA may be disposed outside the first emission driver EDC1. The dam area DAMA may be disposed to be closer to the edge EG1 of the first side of the display panel 110 than the first emission driver EDC1 is.

The dam area DAMA includes a first dam DAM1 and a second dam DAM2. In the non-display area NDA on the first side of the display panel 110, each of the first dam DAM1 and the second dam DAM2 may extend in the second direction DR2.

The first dam DAM1 may be disposed outside the first emission driver EDC1, and the second dam DAM2 may be disposed outside the first dam DAM1. The first dam DAM1 may be disposed between the first emission driver EDC1 and the second dam DAM2. The second dam DAM2 may be disposed closer to the edge EG1 of the first side of the display panel 110 than the first dam DAM1 is.

While FIGS. 6 to 8 illustrate that the dam area DAMA includes two dams DAM1 and DAM2, the present disclosure is not limited thereto, and the number of dams included in the dam area DAMA may be variously modified as needed or desired.

The inorganic area VAL may be an area where organic films 160 and 180 (e.g., see FIGS. 14 to 16) are removed, and inorganic films are disposed, in order to prevent or substantially prevent the permeation of oxygen and/or moisture through the organic films 160 and 180 adjacent to the edge EG1 of the first side of the display panel 110. The inorganic area VAL may extend in the second direction DR2 in the non-display area NDA on the first side of the display panel 110.

The inorganic area VAL may be disposed between any two drivers that are adjacent to each other from among the write scan driver GWC, the control scan driver GCC, the initialization scan driver GIC, and/or the bias scan driver GBC of the first scan driver GDC1. The inorganic area VAL may be disposed between the control scan driver GCC and the initialization scan driver GIC that are adjacent to each other, as illustrated in FIG. 6. In this case, the inorganic area VAL may be disposed between the control scan stages GCST and initialization scan stages GIST.

However, the position where the inorganic area VAL is disposed is not limited to that illustrated in FIG. 6. For example, the inorganic area VAL may be disposed between the write scan driver GWC and the control scan driver GCC that are adjacent to each other. In this case, the inorganic area VAL may be disposed between the write scan stages GWST and the control scan stages GCST.

As another example, the inorganic area VAL may be disposed between the initialization scan driver GIC and the bias scan driver GBC that are adjacent to each other. In this case, the inorganic area VAL may be disposed between the initialization scan stages GIST and the bias scan stages GBST.

As another example, the inorganic area VAL may be disposed between the bias scan driver GBC and the first emission driver EDC1. In this case, the inorganic area VAL may be disposed between the bias scan stages GBST and the light emitting stages EST.

The inorganic area VAL may include a groove Gval (e.g., see FIGS. 15 and 16) in which the organic films 160 and 180 (e.g., see FIGS. 14 to 16) are removed. The groove Gval (e.g., see FIGS. 15 and 16) of the inorganic area VAL may have a cross-sectional shape that is grooved in a V shape like a valley.

Referring to FIG. 7, the common electrode CE may be disposed over the entire or substantially entire display area DA. In the non-display area NDA on the first side of the display panel 110, the common electrode CE may overlap with the write scan driver GWC, the control scan driver GCC, and the initialization scan driver GIC of the first scan driver GDC1. In the non-display area NDA on the first side of the display panel 110, the common electrode CE may overlap with the inorganic area VAL.

In the non-display area NDA on the first side of the display panel 110, the common electrode CE may not overlap with the bias scan driver GBC of the first scan driver GDC1 and the first emission driver EDC1, as illustrated in FIG. 7, but the arrangement is not limited thereto. For example, in the non-display area NDA on the first side of the display panel 110, the common electrode CE may overlap with the bias scan driver GBC of the first scan driver GDC1. In addition, in the non-display area NDA on the first side of the display panel 110, the common electrode CE may overlap with the first emission driver EDC1.

Referring to FIG. 8, in the non-display area NDA on the first side of the display panel 110, the light blocking layer BM of a cover substrate CSUB (e.g., see FIGS. 14 to 16) may overlap with the dam area DAMA, the first emission driver EDC1, the bias scan driver GBC of the first scan driver GDC1, and the initialization scan driver GIC of the first scan driver GDC1. In the non-display area NDA on the first side of the display panel 110, the light blocking layer BM of the cover substrate CSUB (e.g., see FIGS. 14 to 16) may overlap with the inorganic area VAL.

In the non-display area NDA on the first side of the display panel 110, the light blocking layer BM of the cover substrate CSUB (e.g., see FIGS. 14 to 16) may overlap with the control scan driver GCC of the first scan driver GDC1, as illustrated in FIG. 8, but the present disclosure is not limited thereto. For example, in the non-display area NDA on the first side of the display panel 110, the light blocking layer BM of the cover substrate CSUB (e.g., see FIGS. 14 to 16) may not overlap with the control scan driver GCC of the first scan driver GDC1.

In addition, in the non-display area NDA on the first side of the display panel 110, the light blocking layer BM of the cover substrate CSUB (e.g., see FIGS. 14 to 16) may not overlap with the write scan driver GWC of the first scan driver GDC1, as illustrated in FIG. 8, but the arrangement is not limited thereto. For example, in the non-display area NDA on the first side of the display panel 110, the light blocking layer BM of the cover substrate CSUB (e.g., see FIGS. 14 to 16) may overlap with the write scan driver GWC of the first scan driver GDC1.

In the non-display area NDA on the first side of the display panel 110, the common electrode CE overlaps with the inorganic area VAL, and thus, may be disposed in the groove Gval (e.g., see FIGS. 15 and 16) in which the organic films 160 and 180 (e.g., see FIGS. 14 to 16) are removed. Because the groove Gval (e.g., see FIGS. 15 and 16) of the organic films 160 and 180 have a cross-sectional shape that is grooved in a V shape like a valley, when external light is incident on the common electrode CE disposed in the groove Gval, the external light may be unpredictably diffusely reflected.

In the non-display area NDA on the first side of the display panel 110, the light blocking layer BM of the cover substrate CSUB (e.g., see FIGS. 14 to 16) may overlap with the inorganic area VAL, and thus, it may be possible to block the external light incident on the common electrode CE disposed in the groove Gval of the inorganic area VAL. Therefore, it may be possible to prevent or reduce a phenomenon in which the external light incident on the common electrode CE disposed in the groove Gval (e.g., see FIGS. 15 and 16) of the inorganic area VAL is unpredictably diffusely reflected to lower the visibility of an image displayed in the display area.

The area A4 illustrated in FIG. 2 is the same or substantially the same as the area A1 described above with reference to FIGS. 6 to 8, except that the first scan driver GDC1 and the first emission driver EDC1 are replaced with the second scan driver GDC2 and the second emission driver EDC2, and the area A4 is bilaterally symmetrical or substantially symmetrical to the area A1 described above with reference to FIGS. 6 to 8. Therefore, redundant description of the area A4 illustrated in FIG. 2 may not be repeated.

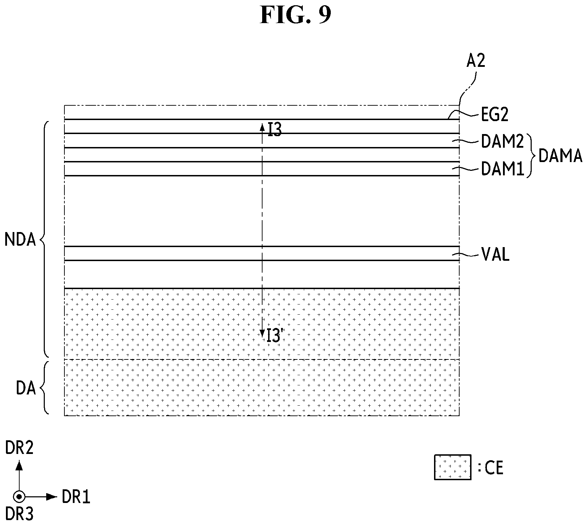

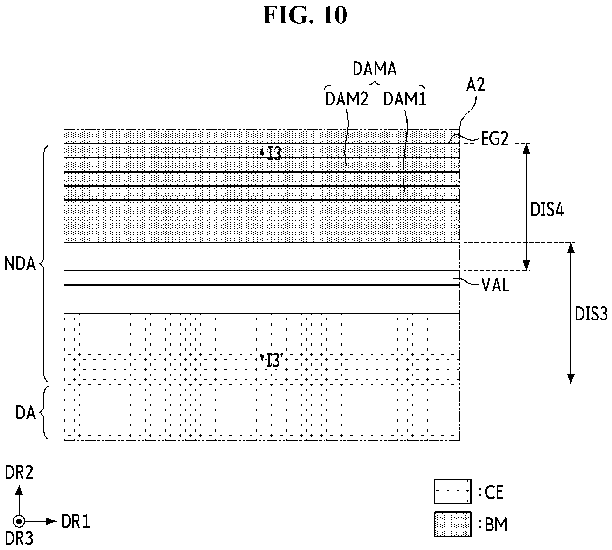

FIGS. 9 and 10 are layout diagrams illustrating examples of the area A2 in FIG. 2 in more detail.

FIGS. 9 and 10 are layout diagrams illustrating, in more detail, the non-display area NDA disposed on the upper side of the display panel 110 corresponding to a third side of the display panel 110. FIG. 10 is a diagram additionally illustrating the light blocking layer BM in addition to the structure illustrated in FIG. 9.

Referring to FIGS. 9 and 10, the inorganic area VAL and the dam area DAMA may be disposed in the non-display area NDA on the third side of the display panel 110. The first scan driver GDC1 and the first emission driver EDC1 may not be disposed in the non-display area NDA on the third side of the display panel 110.

The dam area DAMA may be disposed outside the inorganic area VAL. A distance between the dam area DAMA and the inorganic area VAL may be greater than a distance between the dam area DAMA and an edge EG2 of the third side of the display panel 110.

In the non-display area NDA on the third side of the display panel 110, each of the first dam DAM1 and the second dam DAM2 of the dam area DAMA may extend in the first direction DR1.

The first dam DAM1 may be disposed outside the inorganic area VAL, and the second dam DAM2 may be disposed outside the first dam DAM1. The first dam DAM1 may be disposed between the inorganic area VAL and the second dam DAM2. The second dam DAM2 may be disposed closer to the edge EG2 of the third side of the display panel 110 than the first dam DAM1 is. The dam area DAMA may overlap with the light blocking layer BM of the cover substrate CSUB (e.g., see FIGS. 14 to 16), as illustrated in FIG. 10.

While FIGS. 9 and 10 illustrate that the dam area DAMA includes two dams DAM1 and DAM2, the present disclosure is not limited thereto, and the number of dams included in the dam area DAMA may be variously modified as needed or desired.

In the non-display area NDA on the third side of the display panel 110, the inorganic area VAL may extend in the first direction DR1. The inorganic area VAL may be disposed between the dam area DAMA and the display area DA. In the non-display area NDA on the third side of the display panel 110, the inorganic area VAL may not overlap with the common electrode CE, as illustrated in FIG. 9. In the non-display area NDA on the third side of the display panel 110, the inorganic area VAL may be disposed to be spaced apart (e.g., disposed to be away) from the common electrode CE, as illustrated in FIG. 9.

In the non-display area NDA on the third side of the display panel 110, the inorganic area VAL may not overlap with the light blocking layer BM of the cover substrate CSUB (e.g., see FIGS. 14 to 16), as illustrated in FIG. 10.

A distance DIS1 (e.g., see FIG. 8) between the light blocking layer BM of the cover substrate CSUB (e.g., see FIGS. 14 to 16) in the non-display area NDA on the first side of the display panel 110 and the display area DA may be the same or substantially the same as a distance DIS3 (e.g., see FIG. 10) between the light blocking layer BM of the cover substrate CSUB in the non-display area NDA on the third side of the display panel 110 and the display area DA. On the other hand, a distance DIS2 (e.g., see FIG. 8) between the inorganic area VAL and the edge EG1 of the display panel 110 in the non-display area NDA on the first side of the display panel 110 may be greater than a distance DIS4 (e.g., see FIG. 10) between the inorganic area VAL and the edge EG2 of the display panel 110 in the non-display area NDA on the third side of the display panel 110.

In other words, the distances from the light blocking layer BM in both the non-display area NDA on the first side of the display panel 110 and the non-display area NDA on the third side of the display panel 110 to the display area DA may be the same or substantially the same as each other. However, because the scan driver and the emission driver may not be disposed in the non-display area NDA on the third side of the display panel 110, a width of the non-display area NDA on the third side of the display panel 110 may be smaller than a width of the non-display area NDA on the first side of the display panel 110. Accordingly, in the non-display area NDA on the third side of the display panel 110, the inorganic area VAL may be disposed to be closer to the edge EG2 of the display panel 110, and thus, may be exposed without overlapping with the light blocking layer BM of the cover substrate CSUB (e.g., see FIGS. 14 to 16). However, the common electrode CE may not overlap with the inorganic area VAL, and thus, may not be disposed in the groove Gval (e.g., see FIGS. 15 and 16) of the inorganic area VAL. Therefore, even though external light is incident on the inorganic area VAL, a diffuse reflection of the external light may be reduced or prevented. Accordingly, it may be possible to prevent or reduce the visibility of the image displayed in the display area DA from being lowered.

The area A5 illustrated in FIG. 2 may be the same or substantially the same as the area A2 described above with reference to FIGS. 9 and 10. Therefore, redundant description of the area A5 illustrated in FIG. 2 may not be repeated.

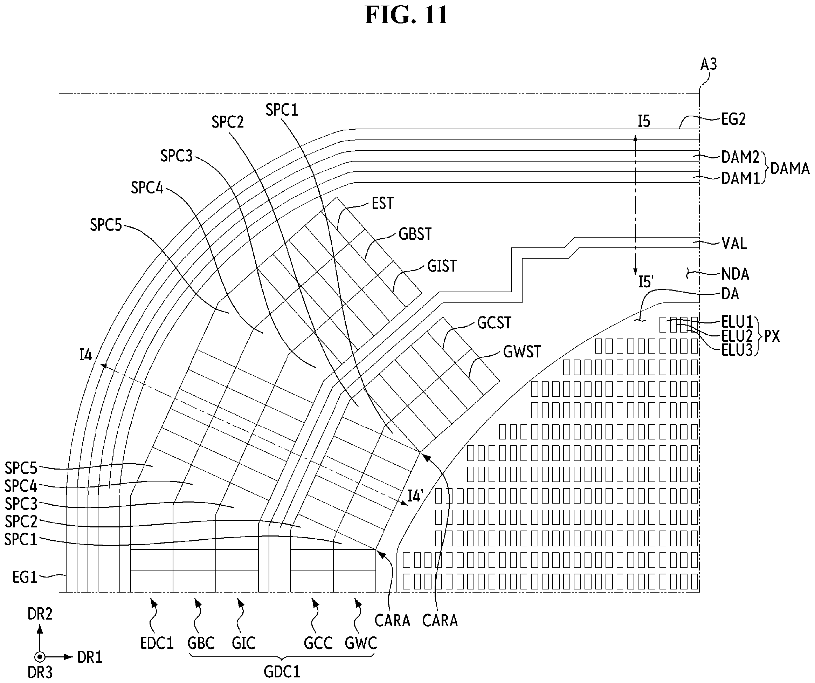

FIGS. 11 through 13 are layout diagrams illustrating examples of the area A3 in FIG. 2 in more detail.

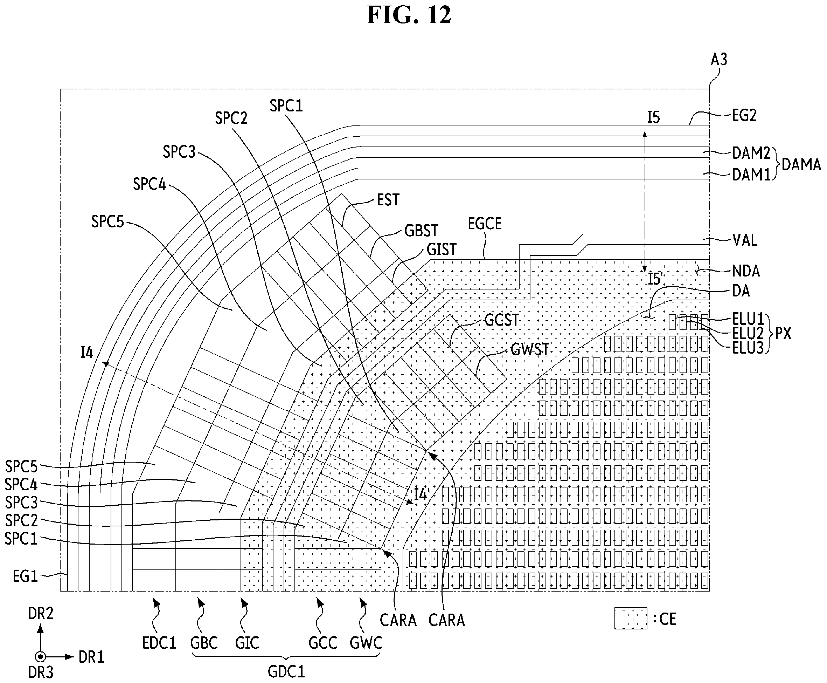

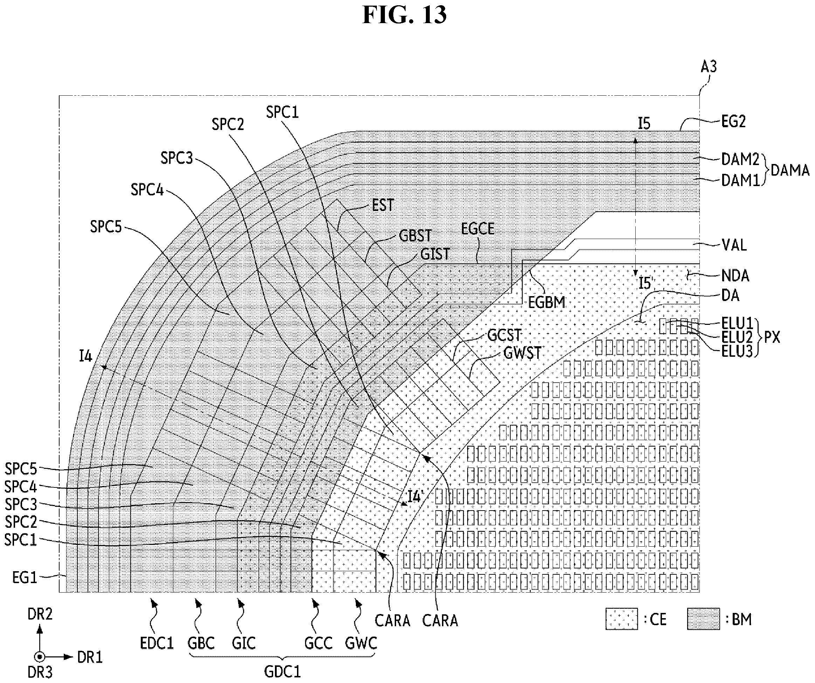

FIGS. 11 to 13 are layout diagrams illustrating, in more detail, the non-display area NDA disposed at a first corner where the first side and the third side of the display panel 110 meet each other. FIG. 12 is a diagram additionally illustrating the common electrode CE in addition to the structure illustrated in FIG. 11. FIG. 13 is a diagram additionally illustrating the light blocking layer BM in addition to the structure illustrated in FIG. 12.

Referring to FIGS. 11 to 13, the first scan driver GDC1, the first emission driver EDC1, the inorganic area VAL, and the dam area DAMA may be disposed in the non-display area NDA at the first corner of the display panel 110.

The first corner of the display panel 110 may have a rounded shape with a suitable curvature (e.g., a predetermined curvature) in a plan view. The write scan driver GWC, the control scan driver GCC, the initialization scan driver GIC, and the bias scan driver GBC of the first scan driver GDC1 may be bent at least once along the curvature of the first corner. While FIGS. 11 to 13 illustrate that the write scan driver GWC, the control scan driver GCC, the initialization scan driver GIC, and the bias scan driver GBC of the first scan driver GDC1 are bent twice along the curvature of the first corner, the present disclosure is not limited thereto.

Because the first corner of the display panel 110 has the rounded shape with the curvature in a plan view, each of the write scan driver GWC, the control scan driver GCC, the initialization scan driver GIC, and the bias scan driver GBC of the first scan driver GDC1 may have a greater length at an outer side thereof than at an inner side thereof. As such, a first space SPC1 may be disposed between the write scan stages GWST neighboring (e.g., adjacent to) each other in a bending section CARA of the write scan driver GWC. Signal lines connecting between the write scan stages GWST neighboring (e.g., adjacent to) each other in the bending section CARA of the write scan driver GWC may be disposed in the first space SPC1.

A second space SPC2 may be disposed between the control scan stages GCST neighboring (e.g., adjacent to) each other in a bending section CARA of the control scan driver GCC. Signal lines connecting between the control scan stages GCST neighboring (e.g., adjacent to) each other in the bending section CARA of the control scan driver GCC may be disposed in the second space SPC2.

A third space SPC3 may be disposed between the initialization scan stages GIST neighboring (e.g., adjacent to) each other in a bending section CARA of the initialization scan driver GIC. Signal lines connecting between the initialization scan stages GIST neighboring (e.g., adjacent to) each other in the bending section CARA of the initialization scan driver GIC may be disposed in the third space SPC3.

A fourth space SPC4 may be disposed between the bias scan stages GBST neighboring (e.g., adjacent to) each other in a bending section CARA of the bias scan driver GBC. Signal lines connecting between the bias scan stages GBST neighboring (e.g., adjacent to) each other in the bending section CARA of the bias scan driver GBC may be disposed in the fourth space SPC4.

In addition, the first emission driver EDC1 may also be bent at least once along the curvature of the first corner. While FIGS. 11 to 13 illustrate that the first emission driver EDC1 is bent twice along the curvature of the first corner, the present disclosure is not limited thereto.

Because the first corner of the display panel 110 has the rounded shape with the curvature in a plan view, the first emission driver EDC1 may have a greater length at an outer side thereof than at an inner side thereof. Accordingly, a fifth space SPC5 may be disposed between a plurality of emission stages GWST neighboring (e.g., adjacent to) each other in a bending section CARA of the first emission driver EDC1. Signal lines connecting between the plurality of emission stages GWST neighboring (e.g., adjacent to) each other in the bending section CARA of the first emission driver EDC1 may be disposed in the fifth space SPC5.

An area of the second space SPC2 may be greater than an area of the first space SPC1, and an area of the third space SPC3 may be greater than the area of the second space SPC2. In addition, an area of the fourth space SPC4 may be greater than the area of the third space SPC3, and an area of the fifth space SPC5 may be greater than the area of the fourth space SPC4.

Referring to FIG. 12, in the non-display area NDA at the first corner of the display panel 110, the common electrode CE may overlap with the write scan driver GWC, the control scan driver GCC, and the initialization scan driver GIC of the first scan driver GDC1. In the non-display area NDA at the first corner of the display panel 110, the common electrode CE may overlap with a first portion of the inorganic area VAL. In the non-display area NDA at the first corner of the display panel 110, the common electrode CE may not overlap with a second portion of the inorganic area VAL. In the non-display area NDA at the first corner of the display panel 110, the first portion of the inorganic area VAL may be a portion that is disposed between the control scan driver GCC and the initialization scan driver GIC. The second portion of the inorganic area VAL may be a portion that is not disposed between the control scan driver circuit GCC and the initialization scan driver circuit GIC. The first portion of the inorganic area VAL may be a portion connected to the inorganic area VAL disposed in the non-display area NDA on the first side of the display panel 110. The second portion of the inorganic area VAL may be a portion connected to the inorganic area VAL disposed in the non-display area NDA on the third side of the display panel 110.

Referring to FIG. 13, in the non-display area NDA at the first corner of the display panel 110, the light blocking layer BM of the cover substrate CSUB (e.g., see FIGS. 14 to 16) may overlap with the dam area DAMA, the first emission driver EDC1, the bias scan driver GBC of the first scan driver GDC1, and the initialization scan driver GIC of the first scan driver GDC1. In the non-display area NDA at the first corner of the display panel 110, the light blocking layer BM of the cover substrate CSUB (e.g., see FIGS. 14 to 16) may overlap with the inorganic area VAL.

In the non-display area NDA at the first corner of the display panel 110, an edge EGCE of the common electrode CE and the inorganic area VAL may overlap with each other. For example, a first portion of the edge EGCE of the common electrode CE may be disposed outside the first portion of the inorganic area VAL, and the second portion of the inorganic area VAL may be disposed outside a second portion of the edge EGCE of the common electrode CE.

In the non-display area NDA at the first corner of the display panel 110, the edge EGCE of the common electrode CE and an edge EGBM of the light blocking layer BM of the cover substrate CSUB (e.g., see FIGS. 14 to 16) may cross each other. For example, the first portion of the edge EGCE of the common electrode CE may be disposed outside a first portion of the edge EGBM of the light blocking layer BM of the cover substrate CSUB (e.g., see FIGS. 14 to 16), and a second portion of the edge EGBM of the light blocking layer BM of the cover substrate CSUB may be disposed outside the second portion of the edge EGCE of the common electrode CE.

In the non-display area NDA at the first corner of the display panel 110, the edge EGBM of the light blocking layer BM of the cover substrate CSUB (e.g., see FIGS. 14 to 16) and the inorganic area VAL may cross each other. For example, the first portion of the edge EGBM of the light blocking layer BM of the cover substrate CSUB may be disposed inside the first portion of the inorganic area VAL, and the second portion of the inorganic area VAL may be disposed inside the second portion of the edge EGBM of the light blocking layer BM of the cover substrate CSUB.

In the non-display area NDA at the first corner of the display panel 110, the light blocking layer BM of the cover substrate CSUB (e.g., see FIGS. 14 to 16) overlaps with the inorganic area VAL, and thus, it may be possible to block the external light incident on the common electrode CE disposed in the groove Gval (e.g., see FIGS. 15 and 16) of the inorganic area VAL. Therefore, it may be possible to prevent or reduce a phenomenon in which the external light incident on the common electrode CE disposed in the groove Gval (e.g., see FIGS. 15 and 16) of the inorganic area VAL is unpredictably diffusely reflected to lower the visibility of an image displayed in the display area.

The area A6 illustrated in FIG. 2 is the same or substantially the same as the area A4 described above with reference to FIGS. 11 to 13, except that the first scan driver GDC1 and the first emission driver EDC1 are replaced with the second scan driver GDC2 and the second emission driver EDC2, and the area A6 is bilaterally symmetrical to the area A4 described above with reference to FIGS. 11 to 13. Therefore, redundant description of the area A6 illustrated in FIG. 2 may not be repeated.

FIG. 14 is a cross-sectional view of the display panel taken along the line I1-I1' in FIG. 5. For example, FIG. 14 illustrates a cross section of the display panel 110 including the first light emitting unit ELU1, the second light emitting unit ELU2, and the third light emitting unit ELU3 in the display area DA.

Referring to FIG. 14, the substrate SUB may include (e.g., may be made of) an insulating material, such as glass or a polymer resin.

A barrier film BR may be disposed on the substrate SUB. The barrier film BR may protect first and second thin film transistors TFT1 and TFT2 and a light emitting layer EL from moisture permeating through the substrate SUB, which may be vulnerable to moisture permeation. The barrier film BR may include a plurality of inorganic films that are alternately stacked.

The first thin film transistor TFT1 may be disposed on the barrier film BR. The first thin film transistor TFT1 may be any one of the fifth transistor T5 or the sixth transistor T6 illustrated in FIG. 4. The first thin film transistor TFT1 may include a first active layer ACT1 and a first gate electrode G1.

The first active layer ACT1 of the first thin film transistor TFT1 may be disposed on the barrier film BR. The first active layer ACT1 of the first thin film transistor TFT1 may include polycrystalline silicon, a single crystal silicon, a low-temperature polycrystalline silicon, or amorphous silicon.

The first active layer ACT1 may include a first channel region CHA1, a first source region S1, and a first drain region D1. The first channel region CHA1 may be a region overlapping with the first gate electrode G1 in a third direction DR3, which is a thickness direction of the substrate SUB. The third direction DR3 may be defined as the thickness direction of the substrate SUB or the thickness direction of the display panel 110. The first source region S1 may be disposed on one side of the first channel region CHA1, and the first drain region D1 may be disposed on another side (e.g., an opposite side) of the first channel region CHA1. The first source region S1 and the first drain region D1 may be regions that do not overlap with the first gate electrode G1 in the third direction DR3. The first source region S1 and the first drain region D1 may be regions having a conductivity by doping a semiconductor material with ions.

A first gate insulating film 131 may be disposed on the first channel region CHA1, the first source region S1, and the first drain region D1 of the first thin film transistor TFT1.

A first gate metal layer may be disposed on the first gate insulating film 131. The first gate metal layer may include the first gate electrode G1 of the first thin film transistor TFT1, and a first capacitor electrode CAE1. The first gate electrode G1 may overlap with the first active layer ACT1 in the third direction DR3.

A second gate insulating film 132 may be disposed on the first gate electrode G1 of the first thin film transistor TFT1 and the first capacitor electrode CAE1.

A second gate metal layer may be disposed on the second gate insulating film 132. The second gate metal layer may include a second capacitor electrode CAE2. The second capacitor electrode CAE2 may overlap with the first capacitor electrode CAE1 in the third direction DR3. Because the second gate insulating film 132 has a suitable dielectric constant (e.g., a predetermined dielectric constant), the capacitor Cst (e.g., see FIG. 4) may be formed by the first capacitor electrode CAE1, the second capacitor electrode CAE2, and the second gate insulating film 132 disposed between the first capacitor electrode CAE1 and the second capacitor electrode CAE2.

A first interlayer insulating film 141 may be disposed on the second capacitor electrode CAE2.

The second thin film transistor TFT2 may be disposed on the first interlayer insulating film 141. The second thin film transistor TFT2 may be any one of the second transistor T2 or the third transistor T3 illustrated in FIG. 4. The second thin film transistor TFT2 may include a second active layer ACT2 and a second gate electrode G2.

The second active layer ACT2 of the second thin film transistor TFT2 may be disposed on the first interlayer insulating film 141. The second active layer ACT2 may include an oxide semiconductor. For example, the second active layer ACT2 may include IGZO (indium (In), gallium (Ga), zinc (Zn), and oxygen (O)), IGZTO (indium (In), gallium (Ga), zinc (Zn), tin (Sn), and oxygen (O)), or IGTO (indium (In), gallium (Ga), tin (Sn) and oxygen (O)).

The second active layer ACT2 may include a second channel region CHA2, a second source region S2, and a second drain region D2. The second channel region CHA2 may be a region overlapping with the second gate electrode G2 in the third direction DR3. The second source region S2 may be disposed on one side of the second channel region CHA2, and the second drain region D2 may be disposed on another side (e.g., an opposite side) of the second channel region CHA2. The second source region S2 and the second drain region D2 may be regions that do not overlap with the second gate electrode G2 in the third direction DR3. The second source region S2 and the second drain region D2 may be regions having a conductivity by doping an oxide semiconductor with ions.

A third gate insulating film 133 may be disposed on the second active layer ACT2 of the second thin film transistor TFT2.

A third gate metal layer may be disposed on the third gate insulating film 133. The third gate metal layer may include the second gate electrode G2 of the second thin film transistor TFT2. The second gate electrode G2 may overlap with the second active layer ACT2 in the third direction DR3.

A second interlayer insulating film 142 may be disposed on the second gate electrode G2 of the second thin film transistor TFT2.

A first data metal layer may be disposed on the second interlayer insulating film 142. The first data metal layer may include a first connection electrode BE1, a second connection electrode BE2, and a third connection electrode BE3. The first connection electrode BE1 may be connected to the first drain region D1 of the first active layer ACT1 through a first connection hole BCT1 penetrating through the first gate insulating film 131, the second gate insulating film 132, the first interlayer insulating film 141, the third gate insulating film 133, and the second interlayer insulating film 142. The second connection electrode BE2 may be connected to the second source region S2 of the second active layer ACT2 through a second connection hole BCT2 penetrating through the second interlayer insulating film 142 and the third gate insulating film 133. The third connection electrode BE3 may be connected to the second drain region D2 of the second active layer ACT2 through a third connection hole BCT3 penetrating through the second interlayer insulating film 142.

A first organic film 160 for planarizing or substantially planarizing a step due to the first thin film transistor TFT1 and the second thin film transistor TFT2 may be disposed on the first connection electrode BE1, the second connection electrode BE2, and the third connection electrode BE3.

A second data metal layer may be disposed on the first organic film 160. The second data metal layer may include a fourth connection electrode BE4. The fourth connection electrode BE4 may be connected to the first connection electrode BE1 through a fourth connection hole BCT4 penetrating through the first organic film 160.

A second organic film 180 may be disposed on the fourth connection electrode BE4.

Each of the barrier film BR, the first gate insulating film 131, the second gate insulating film 132, the third gate insulating film 133, the first interlayer insulating film 141, and the second interlayer insulating film 142 may be formed as an inorganic film including (e.g., made of) silicon nitride (SiNₓ), silicon oxynitride (SiON), silicon oxide (SiOₓ), titanium oxide (TiOₓ), or aluminum oxide (AlOₓ).

Each of the first gate metal layer, the second gate metal layer, the third gate metal layer, the first data metal layer, and the second data metal layer may be formed as a single layer or multiple layers including (e.g., made of) any one of molybdenum (Mo), aluminum (Al), chromium (Cr), gold (Au), titanium (Ti), nickel (Ni), neodymium (Nd), copper (Cu), or suitable alloys thereof.

Each of the first organic film 160 and the second organic film 180 may be formed as an organic film including (e.g., made of) an acrylic resin, an epoxy resin, a phenolic resin, a polyamide resin, a polyimide resin, or the like.

A plurality of light emitting elements LE and a bank 190 may be disposed on the second organic film 180. Each of the plurality of light emitting elements LE may include a pixel electrode PXE, a light emitting layer EL, and a common electrode CE. Each of the plurality of light emitting elements LE refers to an element in which holes from the pixel electrode PXE and electrons from the common electrode CE are recombined with each other in the light emitting layer EL to emit light. Each of the plurality of light emitting elements LE may be an organic light emitting diode in which the light emitting layer EL is an organic light emitting layer, but the present disclosure is not limited thereto.

A pixel electrode layer may be disposed on the second organic film 180. The pixel electrode layer may include the pixel electrodes PXE. Each of the pixel electrodes PXE may be connected to the corresponding fourth connection electrode BE4 through a pixel connection hole PCT penetrating through the second organic film 180. Each of the pixel electrodes PXE may be connected to the first source region S1 or the first drain region D1 of the corresponding first thin film transistor TFT1 through the corresponding first connection electrode BE1 and the corresponding fourth connection electrode BE4. Therefore, a voltage controlled by each of the first thin film transistors TFT1 may be applied to the corresponding pixel electrode PXE. The pixel electrode layer may be formed as a single layer or multiple layers including (e.g., made of) any one of molybdenum (Mo), aluminum (Al), chromium (Cr), gold (Au), titanium (Ti), nickel (Ni), neodymium (Nd), copper (Cu), or suitable alloys thereof.

The bank 190 serves to define the first to third light emitting units ELU1, ELU2, and ELU3 of the sub-pixels. As such, the bank 190 may be formed to expose a partial area of the pixel electrode PXE on the second organic film 180. The bank 190 may cover an edge of the pixel electrode PXE.

A spacer 191 for stably supporting a mask in a process of depositing the light emitting layer EL may be disposed on the bank 190.

Each of the bank 190 and the spacer 191 may be formed as an organic film including (e.g., made of) an acrylic resin, an epoxy resin, a phenolic resin, a polyamide resin, a polyimide resin, or the like.

Each of light emitting layers EL may be exposed without being covered by the bank 190, and may be disposed on the pixel electrode PXE corresponding thereto. Each of the light emitting layers EL may include an organic material, and may emit light (e.g., predetermined light). For example, the light emitting layer EL of the first light emitting unit ELU1 may emit the first light, the light emitting layer EL of the second light emitting unit ELU2 may emit the second light, and the light emitting layer EL of the third light emitting unit ELU3 may emit the third light. Each of the light emitting layers EL may include a hole transporting layer, an organic material layer, and an electron transporting layer.

The common electrode CE may be disposed on the light emitting layers EL and the bank 190. The common electrode CE may be formed to cover an upper surface of each of the light emitting layers EL and an upper surface of the bank 190. The common electrode CE may be disposed in common over the entire or substantially entire display area DA. The common electrode CE may also be disposed in a portion of the non-display area NDA.

In a top emission structure, the common electrode CE may include (e.g., may be made of) a transparent conductive material (TCO), such as indium tin oxide (ITO) or indium zinc oxide (IZO), capable of transmitting light therethrough, or a semi-transmissive conductive material, such as magnesium (Mg), silver (Ag), or an alloy of magnesium (Mg) and silver (Ag). When the common electrode CE includes (e.g., is made of) the semi-transmissive conductive material, a light emitting efficiency of each of the light emitting elements LE may be increased by a micro cavity.

An encapsulation layer TFE may be disposed on the common electrode CE. The encapsulation layer TFE may include at least one inorganic film in order to prevent or substantially prevent oxygen and/or moisture from permeating into the light emitting layer EL. In addition, the encapsulation layer TFE may include at least one inorganic film in order to prevent an air gap from occurring in at least one inorganic film due to foreign substances such as dust.

The encapsulation layer TFE may include a first encapsulation inorganic film TFE1, an encapsulation organic film TFE2, and a second encapsulation inorganic film TFE3, which are sequentially stacked. The first encapsulation inorganic film TFE1 may be disposed on the common electrode CE, the encapsulation organic film TFE2 may be disposed on the first encapsulation inorganic film TFE1, and the second encapsulation inorganic film TFE3 may be disposed on the encapsulation organic film TFE2.

The first encapsulation inorganic film TFE1 and the second encapsulation inorganic film TFE3 may be formed as multiple films in which one or more inorganic films of a silicon nitride (SiNₓ) film, a silicon oxynitride (SiON) film, a silicon oxide (SiOₓ) film, a titanium oxide (TiOₓ) film, and/or an aluminum oxide (AlOₓ) film are alternately stacked. The encapsulation organic film TFE2 may be formed as an organic film made of (e.g., including) an acryl resin, an epoxy resin, a phenolic resin, a polyamide resin, or a polyimide resin.

A polarizing film POL for preventing or substantially preventing the visibility from being lowered due to external light may be disposed on the encapsulation layer TFE. The polarizing film POL may include a first base member, a linear polarizer, a phase retardation film such as a λ/4 plate (quarter-wave plate), and a second base member. The polarizing film POL may be replaced with another anti-reflection layer, such as a color filter layer including a plurality of color filters.

A sensor electrode layer including sensor electrodes for sensing a touch may be further disposed between the encapsulation layer TFE and the polarizing film POL.

A cover substrate CSUB may be disposed on the polarizing film POL. The cover substrate CSUB may be attached onto the polarizing film POL by a transparent adhesive material ADL, such as an optically clear adhesive (OCA) film or an optically clear resin (OCR).

FIG. 15 is a cross-sectional view of the display panel taken along the line I2-I2' of FIGS. 6 to 8. FIG. 15 illustrates a cross section of the display panel 110 illustrating the non-display area NDA on the first side of the display panel 110.

Referring to FIG. 15, a write scan transistor GWT of the write scan stage GWST (e.g., see FIG. 6), a control scan transistor GBT of the control scan stage GCST, an initialization scan transistor GIT of the initialization scan stage GIST, a bias scan transistor GBT of the bias scan stage GBST, and an emission control transistor ECT of the emission stage EST may be disposed on the barrier film BR.

The write scan transistor GWT may include a write active layer ACTGW and a write gate electrode GGW. The write active layer ACTGW may include a write channel region CHGW, a write source region SGW, and a write drain region DGW. The write active layer ACTGW may be disposed on the barrier film BR. The write gate electrode GGW may overlap with the write channel region CHGW in the third direction DR3, and may be disposed on the first gate insulating film 131.

The control scan transistor GCT may include a control active layer ACTGC and a control gate electrode GGC. The control active layer ACTGC may include a control channel region CHGC, a control source region SGC, and a control drain region DGC. The control active layer ACTGC may be disposed on the barrier film BR. The control gate electrode GGC may overlap with the control channel region CHGC in the third direction DR3, and may be disposed on the first gate insulating film 131.

The initialization scan transistor GIT may include an initialization active layer ACTGI and an initialization gate electrode GGI. The initialization active layer ACTGI may include an initialization channel region CHGI, an initialization source region SGI, and an initialization drain region DGI. The initialization active layer ACTGI may be disposed on the barrier film BR. The initialization gate electrode GGI may overlap with the initialization channel region CHGI in the third direction DR3, and may be disposed on the first gate insulating film 131.

The bias scan transistor GBT may include a bias active layer ACTGB and a bias gate electrode GGB. The bias active layer ACTGB may include a bias channel region CHGB, a bias source region SGB, and a bias drain region DGB. The bias active layer ACTGB may be disposed on the barrier film BR. The bias gate electrode GGB may overlap with the bias channel region CHGB in the third direction DR3, and may be disposed on the first gate insulating film 131.

The emission control transistor ECT may include an emission active layer ACTE and an emission gate electrode GE. The emission active layer ACTE may include an emission channel region CHE, an emission source region SE, and an emission drain region DE. The emission active layer ACTE may be disposed on the barrier film BR. The emission gate electrode GE may overlap with the emission channel region CHE in the third direction DR3, and may be disposed on the first gate insulating film 131.

Each of the write active layer ACTGW, the control active layer ACTGC, the initialization active layer ACTGI, the bias active layer ACTGB, and the emission active layer ACTE may include polycrystalline silicon, a single crystal silicon, a low-temperature polycrystalline silicon, or amorphous silicon. The first gate metal layer may include the write gate electrode GGW, the control gate electrode GGC, the initialization gate electrode GGI, the bias gate electrode GGB, and the emission gate electrode GE.

The groove Gval penetrating through the first organic film 160 and the second organic film 180 may be disposed in the inorganic area VAL. In the inorganic area VAL, the first organic film 160 and the second organic film 180 adjacent to the edge EG1 of the first side of the display panel 110 may be spaced apart from the first organic film 160 and the second organic film 180 adjacent to the display area DA. In the inorganic area VAL, the first organic film 160 and the second organic film 180 may be disconnected. Therefore, even though oxygen and/or moisture permeates through the first organic film 160 and the second organic film 180 at the edge EG1 of the first side of the display panel 110, it may be possible to prevent or substantially prevent the oxygen and/or the moisture from being transferred to the first organic film 160 and the second organic film 180 adjacent to the display area DA to affect the light emitting layer EL.

The first data metal layer may include a first power connection electrode VSCE1 and a second power connection electrode VSCE2. The first power connection electrode VSCE1 and the second power connection electrode VSCE2 may be disposed on the second interlayer insulating film 142.

The first power connection electrode VSCE1 may be disposed in the groove Gval penetrating through the first organic film 160 and the second organic film 180. The groove Gval may have a V-shaped cross-sectional shape.

The second power connection electrode VSCE2 may be disposed on the second interlayer insulating film 142 that is exposed without being covered by the first organic film 160 in the dam area DAMA.

The first power line VSL includes a first sub-power line SVSL1 and a second sub-power line SVSL2.

The first sub-power line SVSL1 may be disposed on the first organic film 160. The first sub-power line SVSL1 may be connected to the first power connection electrode VSCE1 that is exposed in the groove Gval of the inorganic area VAL. The first sub-power line SVSL1 may be disposed on the second power connection electrode VSCE2 in the dam area DAMA.

The second sub-power line SVSL2 may be disposed on the second organic film 180. The second sub-power line SVSL2 may be disposed on the first sub-power line SVSL1 in the groove Gval of the inorganic area VAL. The second sub-power line SVSL2 may be disposed on the first sub-power line SVSL1 in the dam area DAMA.

For example, the second power connection electrode VSCE2, the first sub-power line SVSL1, and the second sub-power line SVSL2 may be sequentially stacked in the dam area DAMA.

The first sub-power line SVSL1 and the second sub-power line SVSL2 may overlap with the initialization scan driver GIC, the bias scan driver GBC, and the first emission driver EDC1 disposed between the inorganic area VAL and the dam area DAMA.

The common electrode CE may be disposed on the second organic film 180 that is exposed without being covered by the bank 190 and the bank 190. The common electrode CE may be connected to the second sub-power line SVSL2 in the groove Gval of the inorganic area VAL. The common electrode CE may be disposed on sidewalls of the groove Gval of the inorganic area VAL. Accordingly, when external light is incident on the groove Gval of the inorganic area VAL, the external light may be unpredictably diffusely reflected by the common electrode CE disposed on the sidewalls of the groove Gval of the inorganic area VAL.

The first dam DAM1 and the second dam DAM2 may be disposed on the first power line VSL.

The first dam DAM1 and the second dam DAM2 may be structures for preventing or substantially preventing the encapsulation organic film TFE2 from overflowing into the edge EG1 of the first side of the display panel 110. The first dam DAM1 and the second dam DAM2 may be structures for confining the encapsulation organic film TFE2.

The first dam DAM1 may include a first sub-dam SDAM1_1, a second sub-dam SDAM2_1, and a third sub-dam SDAM3_1, which are sequentially stacked on the first power line VSL. The first sub-dam SDAM1_1 may include (e.g., may be made of) the same material as that of the second organic film 180. The second sub-dam SDAM2_1 may include (e.g., may be made of) the same material as that of the bank 190. The third sub-dam SDAM3_1 may include (e.g., may be made of) the same material as that of the spacer 191.

The second sub-power line SVSL2 may be disposed on the first sub-dam SDAM1_1 of the first dam DAM1. The second sub-power line SVSL2 may be disposed to cover the first sub-dam SDAM1_1 of the first dam DAM1. For example, the second sub-power line SVSL2 may be disposed on an upper surface and side surfaces of the first sub-dam SDAM1_1 of the first dam DAM1. The second sub-dam SDAM2_1 of the first dam DAM1 may be disposed on the second sub-power line SVSL2.

The second dam DAM2 may include a first sub-dam SDAM1_2, a second sub-dam SDAM2_2, a third sub-dam SDAM3_2, and a fourth sub-dam SDAM4_2, which are sequentially stacked on the second interlayer insulating film 142. The first sub-dam SDAM1_2 may include (e.g., may be made of) the same material as that of the first organic film 160. The second sub-dam SDAM2_2 may include (e.g., may be made of) the same material as that of the second organic film 180. The third sub-dam SDAM3_2 may include (e.g., may be made of) the same material as that of the bank 190. The fourth sub-dam SDAM4_2 may include (e.g., may be made of) the same material as that of the spacer 191.

The first sub-dam SDAM1_2 of the second dam DAM2 may be disposed on the second power connection electrode VSCE2. In addition, the first sub-power line SVSL1 may be disposed on the first sub-dam SDAM1_2 of the second dam DAM2, and the second sub-dam SDAM2_2 of the second dam DAM2 may be disposed on the first sub-power line SVSL1. In addition, the second sub-power line SVSL2 may be disposed on the second sub-dam SDAM2_2 of the second dam DAM2, and the third sub-dam SDAM3_2 of the second dam DAM2 may be disposed on the second sub-power line SVSL2.

Outside the second dam DAM2, the first encapsulation inorganic film TFE1 and the second encapsulation inorganic film TFE3 may be in contact with each other, such that an inorganic encapsulation area IEA including only the inorganic films may be disposed. An organic film may not be disposed in the inorganic encapsulation area IEA. The display area DA may be surrounded (e.g., around a periphery thereof) by the inorganic encapsulation area IEA, and thus, it may be possible to prevent or substantially prevent external oxygen or moisture from permeating into the light emitting layer EL of the display area DA. The inorganic encapsulation area IEA may be disposed adjacent to the edge EG1 (e.g., see FIGS. 6 to 8) of the first side of the display panel 110. The inorganic encapsulation area IEA may be disposed to be closer to the dam area DAMA than the inorganic area VAL.

The light blocking layer BM may be disposed on one surface of the cover substrate CSUB. The light blocking layer BM may overlap with the groove Gval of the inorganic area VAL in the third direction DR3. Therefore, it may be possible to prevent or substantially prevent external light from being incident on the groove Gval of the inorganic area VAL. Accordingly, it may be possible to prevent or substantially prevent the external light from being unpredictably diffusely reflected by the common electrode CE disposed on the sidewalls of the groove Gval of the inorganic area VAL, and thus, it may be possible to prevent or reduce the visibility of the image displayed in the display area DA from being lowered.

A cross section of the display panel 110 taken along the lines I4-I4' illustrated in FIGS. 11 to 13 is the same or substantially the same as the cross section of the display panel taken along the line I2-I2' described above with reference to FIG. 15, and thus, redundant description thereof may not be repeated.

FIG. 16 is a cross-sectional view of the display panel taken along the line I3-I3' of FIGS. 9 and 10.

FIG. 16 illustrates a cross section of the display panel 110 illustrating the non-display area NDA on the third side of the display panel 110. Hereinafter with reference to FIG. 16, redundant description as those described above with reference to FIG. 15 may not be repeated, and the differences from FIG. 15 may be mainly described in more detail hereinafter.

Referring to FIG. 16, the common electrode CE may be disposed on the second organic film 180 that is exposed without being covered by the bank 190 and the bank 190. The common electrode CE is not disposed in the groove Gval of the inorganic area VAL. The common electrode CE may be connected to the second sub-power line SVSL2.

The light blocking layer BM may be disposed on one surface of the cover substrate CSUB. The light blocking layer BM may not overlap with the groove Gval of the inorganic area VAL in the third direction DR3.

In the non-display area NDA on the third side of the display panel 110, the inorganic area VAL may be exposed without being covered by the light blocking layer BM of the cover substrate CSUB, and thus, external light may be incident on the inorganic area VAL. However, the common electrode CE may be disposed to be spaced apart (e.g., away) from the inorganic area VAL, and thus, may not be disposed in the groove Gval of the inorganic area VAL. Therefore, even though the external light is incident on the inorganic area VAL, a diffuse reflection of the external light may be reduced or prevented. Accordingly, it may be possible to prevent or reduce the visibility of the image displayed in the display area from being lowered.

A cross section of the display panel 110 taken along the lines I5-I5' illustrated in FIGS. 11 through 13 is the same or substantially the same as a cross section of the display panel taken along the line I3-I3' described above with reference to FIG. 16, and thus, redundant description thereof may not be repeated.

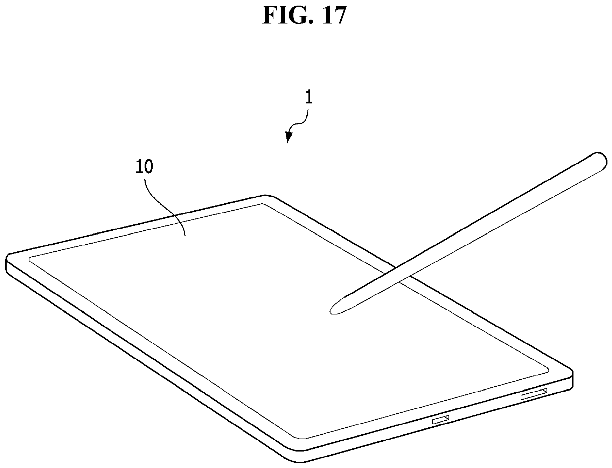

FIG. 17 is a perspective view illustrating an electronic device to which the display device is applied.

Referring to FIG. 17, a tablet personal computer (PC) 1 to which the display device 10 may be applied is illustrated as a representative example of the electronic device. However, the display device 10 may also be applied to other suitable electronic devices, in addition to the tablet PC 1 shown in FIG. 17. For example, the display device 10 may be applied to various suitable electronic devices that display moving images or still images. As an example, the display device 10 may be applied to various suitable portable electronic devices, such as mobile phones, smartphones, smart watches, watch phones, mobile communication terminals, electronic notebooks, electronic books, portable multimedia players (PMPs), navigation devices, and ultra mobile PCs (UMPCs). As another example, the display device 10 may be applied as a display screen of various suitable electronic devices, such as televisions, laptop computers, monitors, billboards, or Internet of Things (IOTs) devices.

The foregoing is illustrative of some embodiments of the present invention, and is not to be construed as limiting thereof. Although some embodiments have been described, those skilled in the art will readily appreciate that various modifications are possible without departing from the scope of the present invention as defined by the claims. It will be understood that descriptions of features or aspects within each embodiment should typically be considered as available for other similar features or aspects in other embodiments, unless otherwise described. Thus, as would be apparent to one of ordinary skill in the art, features, characteristics, and/or elements described in connection with a particular embodiment may be used singly or in combination with features, characteristics, and/or elements described in connection with other embodiments unless otherwise specifically indicated. Therefore, it is to be understood that the foregoing is illustrative of various example embodiments and is not to be construed as limited to the specific embodiments disclosed herein, and that various modifications to the disclosed embodiments, as well as other example embodiments, are intended to be included within the scope of the present invention as defined in the appended claims.

## Claims

1. A display device comprising:
a display panel comprising:
a plurality of light emitting elements in a display area for displaying an image; and
an inorganic area in a non-display area around the display area,
wherein each of the plurality of light emitting elements comprises:
a pixel electrode;
a light emitting layer on the pixel electrode; and
a common electrode on the light emitting layer,
wherein the display panel comprises a first side, a second side opposite to the first side, and a third side connected to the first side and the second side,
wherein, in the non-display area on the first side of the display panel, the common electrode overlaps with the inorganic area, and
wherein, in the non-display area on the third side of the display panel, the common electrode is spaced from the inorganic area.

2. The display device of claim 1, further comprising a cover substrate on the display panel, and comprising a light blocking layer,
wherein, in the non-display area on the first side of the display panel, the light blocking layer overlaps with the inorganic area, and
wherein, in the non-display area on the third side of the display panel, the light blocking layer does not overlap with the inorganic area.

3. The display device of claim 2, wherein, in the non-display area on the first side of the display panel, the common electrode overlaps with the light blocking layer, and
wherein, in the non-display area on the third side of the display panel, the common electrode does not overlap with the light blocking layer.

4. The display device of claim 1, 2 or 3, wherein the display panel further comprises a first corner where the first side and the third side meet each other, and
wherein, in the non-display area at the first corner of the display panel, an edge of the common electrode and the inorganic area cross each other.

5. The display device of claim 2, wherein the display panel further comprises a first corner where the first side and the third side meet each other, and
wherein, in the non-display area at the first corner of the display panel, an edge of the common electrode and an edge of the light blocking layer cross each other.

6. The display device of claim 2, wherein the display panel further comprises a first corner where the first side and the third side meet each other, and
wherein, in the non-display area at the first corner of the display panel, an edge of the light blocking layer and an edge of the inorganic area cross each other.

7. The display device of claim 2, wherein the display panel further comprises:
first scan lines extending in a first direction;
second scan lines extending in the first direction;
a first scan driver in the non-display area on the first side of the display panel, and configured to output first scan signals to the first scan lines; and
a second scan driver in the non-display area on the first side of the display panel, and configured to output second scan signals to the second scan lines, and
wherein, in the non-display area on the first side of the display panel, the inorganic area is located between the first scan driver and the second scan driver.

8. The display device of claim 7, wherein, in the non-display area on the first side of the display panel, the common electrode overlaps with the first scan driver and the second scan driver, or wherein, in the non-display area on the first side of the display panel, the light blocking layer overlaps with the first scan driver and the second scan driver, or wherein, in the non-display area on the first side of the display panel, the light blocking layer overlaps with the second scan driver, and does not overlap with the first scan driver.

9. The display device of claim 7, wherein the display panel further comprises:
third scan lines extending in the first direction; and
a third scan driver in the non-display area on the first side of the display panel, and configured to output third scan signals to the third scan lines, and
wherein, in the non-display area on the first side of the display panel, the third scan driver is located between the first scan driver and the inorganic area.

10. The display device of claim 9, wherein, in the non-display area on the first side of the display panel, the common electrode and/or the light blocking layer overlaps with the first scan driver, the second scan driver, and the third scan driver.

11. The display device of claim 9, wherein, in the non-display area on the first side of the display panel, the light blocking layer overlaps with the second scan driver and the third scan driver, and does not overlap with the first scan driver, or wherein, in the non-display area on the first side of the display panel, the light blocking layer overlaps with the third scan driver, and does not overlap with the first scan driver and the second scan driver.

12. The display device of any one of the preceding claims, wherein the display panel further comprises:
a first encapsulation inorganic film on the plurality of light emitting elements;
an encapsulation organic film on the first encapsulation inorganic film; and
a second encapsulation inorganic film on the encapsulation organic film,
wherein the non-display area comprises an inorganic encapsulation area where the first encapsulation inorganic film and the second encapsulation inorganic film are in contact with each other, and
wherein the inorganic encapsulation area is closer to an edge of the display panel than the inorganic area is.

13. The display device of claim 12, wherein the display panel further comprises a dam in the non-display area, and confining the encapsulation organic film, and
wherein the inorganic encapsulation area is closer to the dam than the inorganic area.

14. A display device comprising:
a display panel comprising:
a plurality of light emitting elements in a display area for displaying an image; and
an inorganic area in a non-display area around the display area; and
a cover substrate on the display panel, and comprising a light blocking layer,
wherein each of the plurality of light emitting elements comprises:
a pixel electrode;
a light emitting layer on the pixel electrode; and
a common electrode on the light emitting layer,
wherein the display panel comprises a first side, a second side opposite to the first side, and a third side connected to the first side and the second side,
wherein, in the non-display area on the first side of the display panel, the common electrode overlaps with the light blocking layer, and
wherein, in the non-display area on the third side of the display panel, the common electrode does not overlap with the light blocking layer.

15. The display device of claim 14, wherein, in the non-display area on the first side of the display panel, the common electrode overlaps with the inorganic area, and
wherein, in the non-display area on the third side of the display panel, the common electrode is spaced from the inorganic area, or wherein, in the non-display area on the first side of the display panel, the light blocking layer overlaps with the inorganic area, and
wherein, in the non-display area on the third side of the display panel, the light blocking layer does not overlap with the inorganic area.
